# EUROPEAN PATENT APPLICATION

(11) **EP 4 750 271 A1**
(43) Date of publication of application: **27.05.2026**
(21) Application number: 25216514.7
(22) Date of filing: 18.11.2025
(51) Int. Cl.: H10F 39/00

(54) **IMAGE SENSOR, ELECTRONIC DEVICE INCLUDING THE IMAGE SENSOR, AND METHOD OF GENERATING HIGH DYNAMIC RANGE (HDR) IMAGE**

(30) Priority: 21.11.2024 KR 20240167753; 12.02.2025 KR 20250018087
(71) Applicant: Samsung Electronics Co., Ltd., Suwon-si, Gyeonggi-do 16677 (KR)
(72) Inventor: LEE, Junho, 16678 Suwon-si (KR); ROH, Sookyoung, 16678 Suwon-si (KR); PARK, Hyunsung, 16678 Suwon-si (KR); MUN, Sangeun, 16678 Suwon-si (KR); AHN, Sungmo, 16678 Suwon-si (KR)
(74) Representative: Elkington and Fife LLP

(57) **Abstract**

Provided is an image sensor including a sensor substrate including a plurality of unit light-sensing cells, each of the plurality of unit light-sensing cells including: a central light-sensing cell, and a plurality of peripheral light-sensing cells surrounding the central light-sensing cell; and a nano optical lens array including: a plurality of unit areas respectively corresponding to the plurality of unit light-sensing cells, and at least one nano structure configured to: condense incident light onto the plurality of unit light-sensing cells, and form a phase profile in which the incident light transmitted through the nano optical lens array is condensed onto the central light-sensing cell and the plurality of peripheral light-sensing cells, wherein the central light-sensing cell is configured to output a first image and the plurality of peripheral light-sensing cells is configured to output a second image.

## Description

### FIELD OF THE INVENTION

The disclosure relates to an image sensor, an electronic device including the image sensor, and a method of generating a high dynamic range (HDR) image.

### BACKGROUND OF THE INVENTION

Image sensors generally sense colors of incident light by using a color filter. However, as a color filter absorbs light of all other colors except for a particular color being filtered by the color filter, the light utilization efficiency of the color filter may be low. For example, when an RGB color filter is used, only one third of incident light is transmitted, and the other two thirds are absorbed, and accordingly, the light utilization efficiency of this color filter may be merely about 33%. Thus, most optical loss occurs at color filters in color display devices or color image sensors.

### SUMMARY OF THE INVENTION

Provided are an image sensor having improved light efficiency by including a nano optical lens array, an electronic device including the image sensor, and a method of generating a high dynamic range (HDR) image by using the electronic device.

Additional aspects will be set forth in part in the description which follows and, in part, will be apparent from the description, or may be learned by practice of the presented embodiments of the disclosure.

According to an aspect of the disclosure, there is provided an image sensor including: a sensor substrate including a plurality of unit light-sensing cells, each of the plurality of unit light-sensing cells including: a central light-sensing cell, and a plurality of peripheral light-sensing cells surrounding the central light-sensing cell; and a nano optical lens array including: a plurality of unit areas respectively corresponding to the plurality of unit light-sensing cells, and at least one nano structure configured to: condense incident light onto the plurality of unit light-sensing cells, and form a phase profile in which the incident light transmitted through the nano optical lens array is condensed onto the central light-sensing cell and the plurality of peripheral light-sensing cells, wherein the central light-sensing cell is configured to output a first image and the plurality of peripheral light-sensing cells is configured to output a second image.

Proposed embodiments relate to an image sensor architecture integrating a nano-optical lens array with a pixel matrix configured for high dynamic range (HDR) imaging. Each pixel unit may include a central light-sensing cell surrounded by multiple peripheral light-sensing cells, allowing distinct capture of light intensities within a single exposure. The nano-optical lens array above the pixel layer may both condense and spectrally separate incident light, creating tailored phase profiles that improve light utilisation and enable HDR image generation from a single shot.

There may be proposed the combination of a sensor substrate having unit light-sensing cells arranged in a 3×3 matrix and a nano-optical lens array forming a corresponding phase profile. Each nano-lens unit area may include nanostructures configured to concentrate incident light onto both central and peripheral cells, while optionally separating wavelengths (e.g. RGB) through nanoscale phase control. The phase profile may follow a Bessel-function distribution to optimise simultaneous focus across multiple sensing cells. The nanostructures-fabricated from high-refractive-index materials such as Si, TiO₂, or GaN-may be arranged with directional symmetry to achieve uniform colour separation and minimal optical loss.

Functionally, the central cell of each unit may act as a high-sensitivity sensor for low-illumination capture, while the surrounding peripheral cells operate at lower sensitivity to prevent saturation in high-illumination regions. The nano-lens array may increase quantum efficiency by up to approximately 48 % at the central cells compared with conventional colour-filter-based sensors, while also reducing optical loss by replacing absorptive filters with transmissive nanostructures. The resulting signals from central and peripheral cells may be processed through pixel-level binning and HDR-merging within the image processor to generate a single, wide-dynamic-range image.

From a manufacturing standpoint, the nano-optical lens array can be formed via lithographically patterned dielectric layers on a transparent spacer, with optional etch-stop and anti-reflection coatings to improve process control and light throughput. The architecture may eliminate the need for complex multi-exposure HDR capture, enabling compact, energy-efficient image sensors well-suited for integration into camera modules for mobile devices and other optical imaging systems.

Embodiments propose a co-operative optical-electrical design whereby a nanoscale phase-modulating lens array directly controls intra-pixel light distribution, thereby enabling single-exposure HDR imaging with enhanced light efficiency and manufacturable alignment tolerance.

Each of the plurality of unit light-sensing cells may include a plurality of light-sensing cells arranged in a 3x3 array, wherein the central light-sensing cell may be provided in a central portion of the 3x3 array, and wherein the peripheral light-sensing cells may be provided in a peripheral portion of the 3x3 array.

The phase profile of the incident light transmitted through the nano optical lens array has a peak at a center of a central corresponding area corresponding to the central light-sensing cell and at a center of each peripheral corresponding area corresponding to the peripheral light-sensing cell.

The at least one nano structure may be further configured to: separate first light of a first wavelength band, second light of a second wavelength band different from the first wavelength band, and third light of a third wavelength band different from the first wavelength band and the second wavelength band from the incident light, and respectively condense the first light, the second light and the third light onto the plurality of unit light-sensing cells.

The plurality of unit light-sensing cells may include a first unit light-sensing cell, a second unit light-sensing cell, a third unit light-sensing cell, and a fourth unit light-sensing cell, wherein the nano optical lens array may include a first unit area corresponding to the first unit light-sensing cell, a second unit area corresponding to the second unit light-sensing cell, a third unit area corresponding to the third unit light-sensing cell, and a fourth unit area corresponding to the fourth unit light-sensing cell, wherein the at least one nano structure may include a first nano structure, a second nano structure, a third nano structure and a fourth nano structure, wherein the first nano structure provided in the first unit area is arranged to separate and condense light of a first wavelength band from the incident light onto the first unit light-sensing cell, wherein the second nano structure provided in the second unit area is arranged to separate and condense light of a second wavelength band from the incident light onto the second unit light-sensing cell, wherein the third nano structure provided in the third unit area is arranged to separate and condense light of a third wavelength band from the incident light onto the third unit light-sensing cell, and wherein the fourth nano structure provided in the fourth unit area is arranged to separate and condense light of a fourth wavelength band from the incident light onto the fourth unit light-sensing cell.

The first nano structure provided in the first unit area may be arranged symmetrically with respect to a first direction, the second nano structure provided in the second unit area may be arranged symmetrically with respect to the first direction and a second direction perpendicular to the first direction, and the fourth nano structure provided in the fourth unit area may be arranged symmetrically with respect to the second direction.

The phase profile of the incident light transmitted through the nano optical lens array may have a form of a Bessel function.

Each of the plurality of unit light-sensing cells may include a plurality of light-sensing cells, and a size of the unit areas is greater than a size of the light-sensing cells.

Each of the plurality of unit light-sensing cells may include a plurality of light-sensing cells, and a size of the unit areas is identical to a size of the light-sensing cells.

According to an aspect of the disclosure, there is provided an electronic device including: a lens assembly forming an optical image of an object; an image sensor configured to convert the optical image formed by the lens assembly into an electric signal; and a processor configured to process a signal generated from the image sensor, wherein the image sensor may include: a sensor substrate including a plurality of unit light-sensing cells, each of the plurality of unit light-sensing cells including: a central light-sensing cell, and a plurality of peripheral light-sensing cells surrounding the central light-sensing cell; and a nano optical lens array including: a plurality of unit areas respectively corresponding to the plurality of unit light-sensing cells, and at least one nano structure configured to: condense incident light onto the plurality of unit light-sensing cells, and form a phase profile in which the incident light transmitted through the nano optical lens array is condensed onto the central light-sensing cell and the plurality of peripheral light-sensing cells, wherein the central light-sensing cell is configured to output a first image and the plurality of peripheral light-sensing cells is configured to output a second image, and wherein the processor configured to obtain a high dynamic range (HDR) image based on the first image and the second image.

According to an aspect of the disclosure, there is provided a method of generating a high dynamic range (HDR) image, the method including: obtaining a single-shot image from a central light-sensing cell of a plurality of unit light-sensing cells and a plurality of peripheral light-sensing cells surrounding the central light-sensing cell; binning images obtained from the plurality of peripheral light-sensing cells in the single-shot image; HDR-merging by using an image obtained by the binning and an image obtained from the central light-sensing cell in the single-shot image; signal processing an image obtained by the HDR-merging; and outputting a HDR image.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic block diagram of an image sensor according to an embodiment;
FIG. 2 is a plan view illustrating an example of a pixel arrangement of a pixel array of an image sensor according to an embodiment;
FIG. 3A is a cross-sectional view of the pixel array of the image sensor taken along line A-A' of FIG. 2, according to an embodiment;'
FIG. 3B is a cross-sectional view of the pixel array of the image sensor taken along line B-B' of FIG. 2, according to an embodiment;
FIG. 4 is a plan view illustrating an arrangement of a plurality of light-sensing cells of a sensor substrate provided in a pixel array of an image sensor according to an embodiment;
FIG. 5 is a plan view illustrating an example of an arrangement of a plurality of nano structures of a nano optical lens array according to an embodiment;
FIG. 6 is a plan view illustrating an example of green light-condensing areas formed by a nano optical lens array of a pixel array of an image sensor according to an embodiment;
FIG. 7 is a plan view illustrating an example of red light-condensing areas formed by a nano optical lens array of a pixel array of an image sensor according to an embodiment;
FIG. 8 is a plan view illustrating an example of blue light-condensing areas formed by a nano optical lens array of a pixel array of an image sensor according to an embodiment;
FIGS. 9A, 9B and 9C are diagrams illustrating target phase profiles of the nano optical lens array of FIG. 5;
FIG. 10 is a plan view of a color filter layer of a pixel array of an image sensor according to an embodiment;
FIG. 11A is a cross-sectional view of the pixel array of the image sensor taken along line A-A' of FIG. 2, according to another embodiment, and FIG. 11B is a cross-sectional view of the pixel array of the image sensor taken along line B-B' of FIG. 2, according to another embodiment;
FIGS. 12A, 12B, 12C and 12D are diagrams showing signal intensities at a unit light-sensing cell and target phase profiles of a nano optical lens array of the pixel array of FIGS. 11A and 11B;
FIG. 12E is a diagram showing signal intensity at the unit light-sensing cell according to the phase profile illustrated in FIG. 12 D;
FIGS. 13 and 14 are each a plan view illustrating an example of a pixel arrangement of a pixel array of an image sensor according to another embodiment;
FIG. 15 is a diagram showing graphs for comparing color separation performance between image sensors according to some embodiments and an image sensor according to a comparative example;
FIG. 16 is a block diagram illustrating a high dynamic range (HDR) drive process of an image sensor according to an embodiment;
FIG. 17 is a schematic block diagram of an electronic device including an image sensor, according to an embodiment;
FIG. 18 is a schematic block diagram of a camera module provided in the electronic device of FIG. 17;
FIG. 19 is a block diagram of an electronic device including a multi-camera module; and
FIG. 20 is a detailed block diagram of a single camera module provided in the electronic device of FIG. 19.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Embodiments will now be described more fully with reference to the accompanying drawings. Embodiments described below are provided merely as an example, and various modifications may be made from the embodiments. In the drawings, like reference numerals denote like elements, and sizes of components in the drawings may be exaggerated for clarity and convenience of explanation.

It will be understood that when a component is referred to as being "on" another component or on "upper part" of another component, the component can be directly on the other component or over the other component in a non-contact manner.

While such terms as "first," "second," etc., may be used to describe various components, the above terms are used only to distinguish one component from another. These terms are not intended to define that materials or structures of components are different.

An expression used in the singular encompasses the expression of the plural, unless it has a clearly different meaning in the context. When a portion "includes" a component, another component may be further included, rather than excluding the existence of the other component, unless otherwise described.

Moreover, the terms "part," "module," etc. refer to a unit processing at least one function or operation, and may be implemented by a hardware, a software, or a combination thereof.

The use of the terms "a" and "an" and "the" and similar referents in the context of describing embodiments (especially in the context of the following claims) are to be construed to cover both the singular and the plural.

Also, the steps of all methods described herein can be performed in any suitable order unless otherwise indicated herein or otherwise clearly contradicted by context. The use of any and all exemplary language (e.g., "such as") provided herein, is intended merely to better illuminate technical ideas and does not pose a limitation on the scope of embodiments unless otherwise claimed.

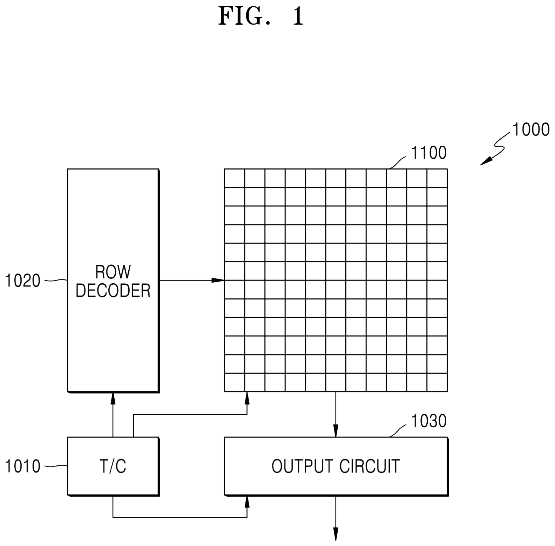

FIG. 1 is a schematic block diagram of an image sensor according to an embodiment. Referring to FIG. 1, an image sensor 1000 may include a pixel array 1100, a timing controller 1010, a row decoder 1020, and an output circuit 1030. The image sensor may be a charge coupled device (CCD) image sensor or a complementary metal oxide semiconductor (CMOS) image sensor.

The pixel array 1100 may include pixels arranged in a two-dimensional manner in a plurality of rows and columns. The row decoder 1020 may select one of the rows of the pixel array 1100 in response to a row address signal output from the timing controller 1010. The output circuit 1030 may output a light sensing signal from a plurality of pixels arranged along the selected row on a column-by-column basis. To this end, the output circuit 1030 may include a column decoder and an analog-to-digital converter (ADC). For example, the output circuit 1030 may include a plurality of ADCs respectively arranged between the column decoder and the pixel array 1100 for each column decoder, or an ADC arranged at an output terminal of the column decoder. The timing controller 1010, the row decoder 1020, and the output circuit 1030 may be implemented in one chip or separate chips. A processor for processing an image signal output through the output circuit 1030 may be implemented in a single chip together with the timing controller 1010, the row decoder 1020, and the output circuit 1030.

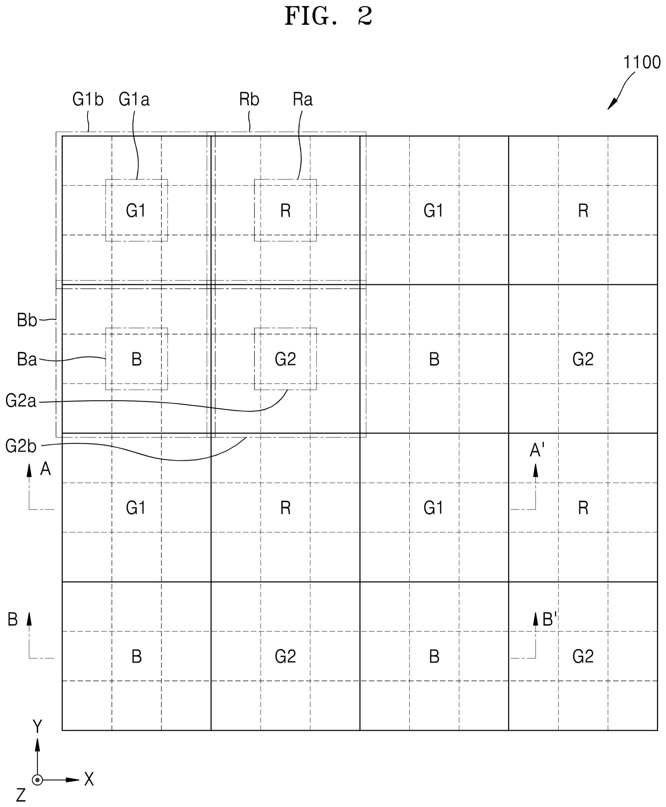

The pixel array 1100 may include a plurality of pixels for sensing light of different wavelengths from each other. The arrangement of the pixels may be implemented in various ways. Each pixel may comprise a plurality of light-sensing cells (i.e. sub-pixels)
The pixel array 1100 may include a plurality of pixels for sensing light of different wavelengths. The arrangement of the pixels may be implemented in various ways. For example, FIG. 2 illustrates an example of a pixel arrangement of the pixel array 1100 of the image sensor 1000 according to an embodiment. Referring to FIG. 2, the pixel array 1100 may include a plurality of unit pixel structures arranged in a two-dimensional (2D) manner. For example, each of a plurality of unit pixels may have structure in which a first green pixel G1, a red pixel R, a blue pixel B, and a second green pixel G2 are arranged in a 2x2 array.

The first green pixel G1, the red pixel R, the blue pixel B, and the second green pixel G2 may each include a plurality of pixels arranged in a 3x3 array. The first green pixel G1, the red pixel R, the blue pixel B, and the second green pixel G2 may each include a central pixel provided at the center and a plurality of peripheral pixels surrounding the central pixel. For example, as illustrated in FIG. 2, a first green central pixel G1a may be provided at the center of the first green pixel G1, and a plurality of first green peripheral pixels G1b may surround the first green central pixel G1a. For example, the first green central pixel G1a may be provided at second row and second column of the first green pixel G1, and the plurality of first green peripheral pixels G1b may be provided at first row and first column, first row and second column, first row and third column, second row and first column, second row and third column, third row and first column, third row and second column, and third row and third column. For example, the first green pixel G1 may include one first green central pixel G1a provided at the center and eight first green peripheral pixels G1b surrounding the first green central pixel G1a.

According to an embodiment, Similarly, a red central pixel Ra may be provided at the center of the red pixel R, and a plurality of red peripheral pixels Rb may surround the red central pixel Ra. A blue central pixel Ba may be provided at the center of the blue pixel B, and a plurality of blue peripheral pixels Bb may surround the blue central pixel Ba. A second green central pixel G2a may be provided at the center of the second green pixel G2, and a plurality of second green peripheral pixels G2b may surround the second green central pixel G2a.

The image sensor 1000 including the pixel array 1100 having such pixel arrangement may be, for example, a high dynamic range (HDR) image sensor. In this case, in an low-light level environment, images may be generated by using signals output from the central pixels, and in a high-light level environment, images may be generated by using signals output from both of the central pixels and the peripheral pixels. Accordingly, the contrast range of images may be improved significantly by using the central pixels having a relatively high sensitivity and the peripheral pixels having a relatively low sensitivity.

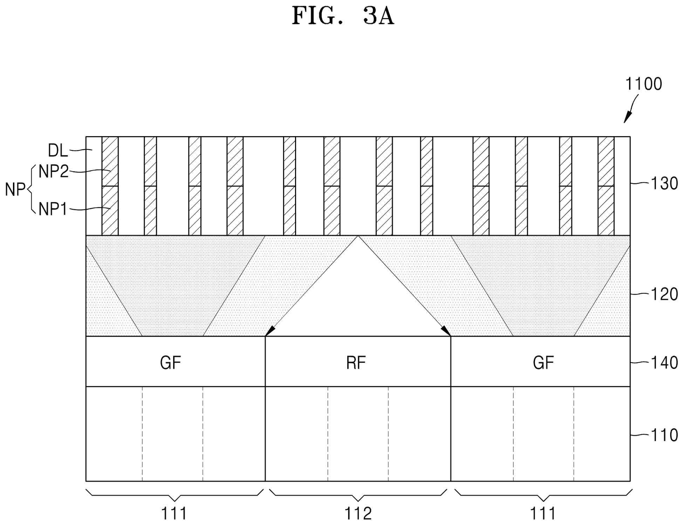

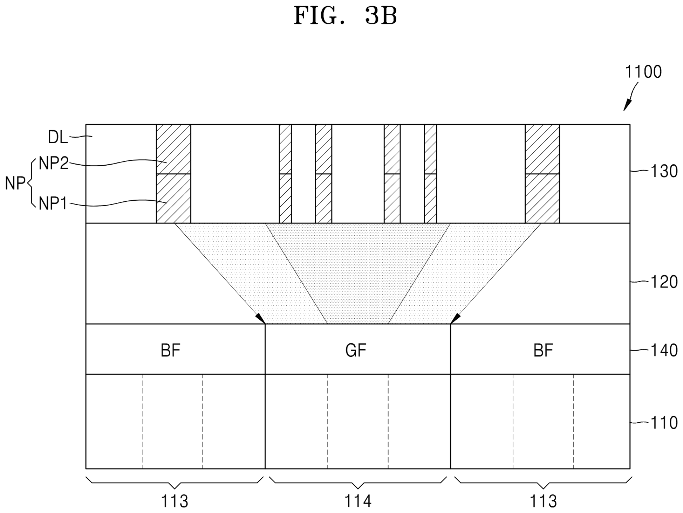

FIG. 3A is a cross-sectional view of a pixel array of an image sensor taken along line A-A' of FIG. 2, according to an embodiment, and FIG. 3B is a cross-sectional view of a pixel array of an image sensor taken along line B-B' of FIG. 2, according to an embodiment.

Referring to FIGS. 3A and 3B, the pixel array 1100 may include a sensor substrate 110 and a nano optical lens array 130 arranged on the sensor substrate 110. According to an embodiment, the pixel array 1100 may include a spacer layer 120 arranged between the sensor substrate 110 and the nano optical lens array 130, and a color filter layer 140 arranged between the sensor substrate 110 and the spacer layer 120. However, the disclosure is not limited thereto, and as such, according to another embodiment, the color filter layer 140 may be omitted.

The sensor substrate 110 may include a plurality of unit light-sensing cells configured to generate image signals by converting incident light into electric signals. For example, the sensor substrate 110 may include a first unit light-sensing cell 111 and a fourth unit light-sensing cell 114 which are configured to sense and convert light of a first wavelength band into an electric signal, a second unit light-sensing cell 112 configured to sense and convert light of a second wavelength band into an electric signal, and a third unit light-sensing cell 113 configured to sense and convert light of a third wavelength band into an electric signal.

The spacer layer 120 may be arranged between the sensor substrate 110 and the nano optical lens array 130 to maintain a constant distance between the sensor substrate 110 and the nano optical lens array 130. The spacer layer 120 may include a material that is transparent with respect to visible light, for example, poly methylmethacrylate (PMMA), siloxane-based spin on glass (SOG), SiO₂, Si₃N₄, Al₂O₃, etc. which are a dielectric material having a lower refractive index than a nano structure NP and a low absorption rage in the visible light band.

The color filter layer 140 may include a plurality of color filters transmitting light of a particular wavelength band and absorbing light of other wavelength bands. For example, the color filter layer 140 may include a green color filter GF configured to transmit light of a first wavelength band and absorb light of other wavelength bands, a red color filter RF configured to transmit light of a second wavelength band and absorb light of other wavelength bands, and a blue color filter BF configured to transmit light of a third wavelength band and absorb light of other wavelength bands.

The green color filter GF may be arranged on the first unit light-sensing cell 111 and the fourth unit light-sensing cell 114, the red color filter RF may be arranged on the second unit light-sensing cell 112, and the blue color filter BF may be arranged on the third unit light-sensing cell 113. According to an embodiment, since the incident light may be color-separated considerably by the nano optical lens array 130, even in an example case in which the color filter layer 140 is used, the absorption loss due to the color filter layer 140 may be small. In addition, since the nano optical lens array 130 and the color filter layer 140 are used together, the color purity may be improved.

The nano optical lens array 130 may include a plurality of nano structures NP and may further include a dielectric layer DL filled between the plurality of nano structures NP. The nano optical lens array 130 may include the plurality of nano structures NP in various manners such that the nano optical lens array 130 may perform the functions of color separation and light condensing described above. For example, the plurality of nano structures NP may be arranged to change a phase of light transmitted through the nano optical lens array 130 according to a location of a phase of the nano optical lens array 130. The phase profile of the transmitted light, which is implemented by the nano optical lens array 130 may be determined according to the size (e.g., width or diameter), shape, height of a cross-section of each of the nano structures NP, an arrangement cycle (or pitch) of the plurality of nano structures NP, and an arrangement pattern of the plurality of nano structures NP. Moreover, the movement of light transmitted through the nano optical lens array 130 may be determined according to the phase profile of the transmitted light.

The nano structures NP may have a size smaller than a wavelength of visible light. The nano structures NP may have, for example, a size smaller than a blue wavelength. For example, a cross-sectional width (or diameter) of the nano structure NP may be 400 nm, 300 nm, or less than 200 nm and greater than 80 nm. The height of the nano structure NP may be about 500 nm to about 1,500 nm and may be greater than the width of the cross-section.

The nano structure NP may include a material having a relatively high refractive index than peripheral materials and a relatively low absorption rate in the visible light band. For example, the nano structure NP may include, but is not limited to, c-Si, p-Si, a-Si, III-V group compound semiconductor (GaP, GaN, GaAs, etc.), SiC, TiO₂, SiN₃, ZnS, ZnSe, Si₃N₄, and/or a combination thereof. The periphery of the nano structures NP may be filled with the dielectric layer DL having a relatively lower refractive index than the nano structures NP and a relatively low absorption rate in the visible light band. For example, the dielectric layer DL may be filled with PMMA, SOG, SiO₂, Si₃N₄, Al₂O₃, air, etc.

The nano structure NP may have a refractive index of 2.0 or greater with respect to light having a wavelength of about 630 nm, and the dielectric layer DL may have a refractive index of 1.0 or greater and less than 2.0 with respect to light having a wavelength of about 630 nm. In addition, a difference between the refractive index of the nano structures NP and the refractive index of the dielectric layer DL may be 0.5 or greater. The nano structure NP having a different refractive index from peripheral materials may change a phase of light passing the nano structure NP. This is due to a phase delay caused by the shape dimension of a subwavelength of the nano structure NP, and the degree of phase delay may be determined by detailed shape dimensions, arrangement, etc. of the nano structure NP.

The nano structure NP may include nano structures (NP1 and NP2) having a multi-layer structure. The nano structure NP may include at least one of a first layer nano structure NP1 and a second layer nano structure NP2. The first layer nano structure NP1 may be arranged on the spacer layer 120, and the second layer nano structure NP2 may be arranged on the first layer nano structure NP1. The arrangement of the first layer nano structure NP1 and the arrangement of the second layer nano structure NP2 may be identical to each other. Or, the arrangement of the first layer nano structure NP1 and the arrangement of the second layer nano structure NP2 may be different from each other.

According to an embodiment, depending on the arrangement of the nano structures NP, the color separation and form of light condensing performed by the nano optical lens array 130 may vary according to a color of the light-sensing cell of the sensor substrate 110 facing the nano optical lens array 130.

According to an embodiment, an etch stop layer may be arranged between the spacer layer 120 and the nano optical lens array 130. The etch stop layer may be provided to protect the spacer layer 120 which is a lower structure of the nano optical lens array 130 in the manufacturing process of the nano optical lens array 130. In an example case in which the nano optical lens array 130 is manufactured on the spacer layer 120, the dielectric layer DL may be fully formed on the spacer layer 120, and an etching process may be performed thereon to a certain depth. In this process, the etching may be performed more than a desired depth, thereby damaging the spacer layer 120, and the color separation performance may be degraded when the thickness of the spacer layer 120 does not meet the requirement for distance between the nano optical lens array 130 and the sensor substrate 110. However, in an example case in which the etch stop layer includes a material having lower etch selectivity than a material etched, the etch stop layer may not be easily removed and may be left, and the spacer layer 120 may be prevented from damage from the etching process. The etch stop layer may include HfO₂. The thickness of the etch stop layer may be determined by considering the etching depth, i.e., the height of the nano structure NP and the etching dispersion in a process wafer. The thickness of the etch stop layer may be about 3 nm to about 30 nm. In addition, in an example case in which the nano structure NP has a multi-layer structure, the etch stop layer may be arranged between nano structure layers.

According to an embodiment, a protective layer for protecting the nano optical lens array 130 may be further arranged on the nano optical lens array 130. For example, the protective layer may include a material that functions as an anti-reflective layer. For example, the anti-reflective layer may reduce light reflected from an upper surface of the nano optical lens array 130 from among the incident light to improve light utilization efficiency of the pixel array 1100. In other words, the anti-reflective layer may prevent the incident light from the outside onto the pixel array 1100 from being reflected from the upper surface of the nano optical lens array 130 and help the incident light travel through the nano optical lens array 130 and be sensed at the sensor substrate 110. The anti-reflective layer may be a structure in which one or more layers are stacked and may include, for example, one layer including a material different from a material included in the nano optical lens array 130 or multiple layers having different refractive indexes from each other.

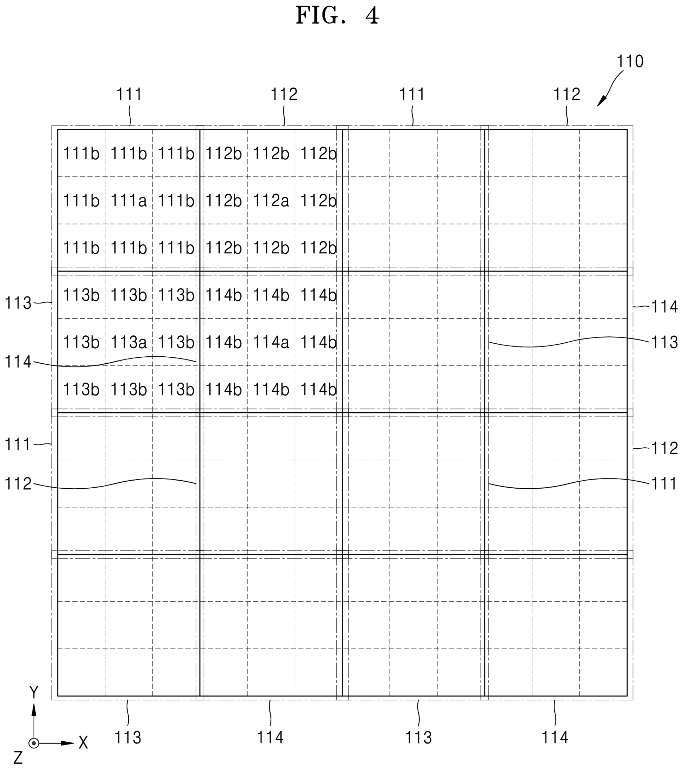

FIG. 4 is a plan view illustrating an arrangement of a plurality of light-sensing cells of a sensor substrate provided in a pixel array of an image sensor according to an embodiment.

Referring to FIG. 4, the sensor substrate 110 may include a plurality of light-sensing cells sensing incident light.

The sensor substrate 110 may include a plurality of unit structures arranged in a 2D manner in a first direction (X direction) and a second direction (Y direction), and each unit structure may include the first unit light-sensing cell 111, the second unit light-sensing cell 112, the third unit light-sensing cell 113, and the fourth unit light-sensing cell 114 which are arranged in a 2x2 array. In addition, each unit structure may include a central light-sensing cell (111a, 112a, 113a, and 114a) and peripheral light-sensing cells (111b, 112b, 113b, and 114b) which are arranged in a 3x3 array.

An HDR image may be obtained by using images obtained from the central light-sensing cell (111a, 112a, 113a, and 114a) and images obtained from the plurality of peripheral light-sensing cells (111b, 112b, 113b, and 114b).

Referring to FIGS. 2 and 4, the first unit light-sensing cell 111 may be provided to correspond to the first green pixel G1, the second unit light-sensing cell 112 may be provided to correspond to the red pixel R, the third unit light-sensing cell 113 may be provided to correspond to the blue pixel B, and the fourth unit light-sensing cell 114 may be provided to correspond to the second green pixel G2. The central light-sensing cell 111a of the first unit light-sensing cell 111 may be provided to correspond to the first green central pixel G1a, and the peripheral light-sensing cells 111b may be provided to correspond to the first green peripheral pixels G1b. The central light-sensing cell 112a of the second unit light-sensing cell 112 may be provided to correspond to the red central pixel Ra, and the peripheral light-sensing cells 112b may be provided to correspond to the red peripheral pixels Rb. The central light-sensing cell 113a of the third unit light-sensing cell 113 may be provided to correspond to the blue central pixel Ba, and the peripheral light-sensing cells 113b may be provided to correspond to the blue peripheral pixels Bb. The central light-sensing cell 114a of the fourth unit light-sensing cell 114 may be provided to correspond to the second green central pixel G2a, and the peripheral light-sensing cells 114b may be provided to correspond to the second green peripheral pixels G2b.

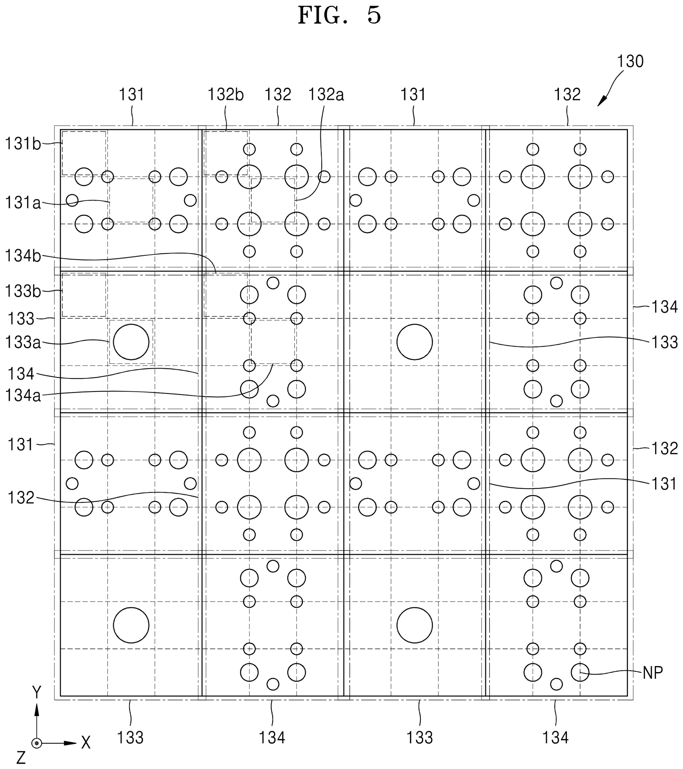

FIG. 5 is a plan view showing how areas of a nano optical lens array provided in a pixel array of an image sensor are divided, according to an embodiment.

Referring to FIG. 5, the nano optical lens array 130 may color-separate and condense incident light. For example, the nano optical lens array 130 may separate the incident light into light of a first wavelength band (e.g., green light), light of a second wavelength band (e.g., red light) which is different from the first wavelength band, and light of a third wavelength band (e.g., blue light) which is different from the first wavelength band and the second wavelength band and render the foregoing lights proceed along different paths from each other. In addition, the nano optical lens array 130 may also function as a lens condensing the separated light of the first wavelength band, light of the second wavelength band, and light of the third wavelength band onto the respective corresponding light-sensing cells.

Referring to FIGS. 4 and 5, the nano optical lens array 130 may include a plurality of unit corresponding areas corresponding to each of the plurality of unit light-sensing cells of the sensor substrate 110. According to an embodiment, the plurality of unit corresponding areas may be referred to as "a plurality of unit areas", but the disclosure is not limited thereto. For example, the nano optical lens array 130 may include a plurality of first unit corresponding areas 131 corresponding to the first unit light-sensing cell 111, a second unit corresponding area 132 corresponding to the second unit light-sensing cell 112, a third unit corresponding area 133 corresponding to the third unit light-sensing cell 113, and a fourth unit corresponding area 134 corresponding to the fourth unit light-sensing cell 114. The size (or surface area) of each of the unit corresponding areas (131, 132, 133, and 134) of the nano optical lens array 130 may be greater than the size (or surface area) of each light-sensing cell.

According to an embodiment, one first unit corresponding area 131, one second unit corresponding area 132, one third unit corresponding area 133, and one fourth unit corresponding area 134 may be grouped to form one unit structure. The first unit corresponding area 131, the second unit corresponding area 132, the third unit corresponding area 133, and the fourth unit corresponding area 134 may be arranged to face the corresponding first unit light-sensing cell 111, second unit light-sensing cell 112, third unit light-sensing cell 113, and fourth unit light-sensing cell 114, respectively in a third direction (Z direction) perpendicular to the first direction and the second direction.

According to an embodiment, the first unit corresponding area 131, the second unit corresponding area 132, the third unit corresponding area 133, and the fourth unit corresponding area 134 which form the nano optical lens array 130 may separate light of the first wavelength band from the incident light and condense the light of the first wavelength band onto the central light-sensing cell 111a and the peripheral light-sensing cells 111b of the first unit light-sensing cell 111 and the central light-sensing cell 114a and the peripheral light-sensing cells 114b of the fourth unit light-sensing cell 114, separate light of the second wavelength band and condense the light of the second wavelength band onto the central light-sensing cell 112a and the peripheral light-sensing cells 112b of the second unit light-sensing cell 112, and separate light of the third wavelength band and condense the light of the third wavelength band onto the central light-sensing cell 113a and the peripheral light-sensing cells 113b of the third unit light-sensing cell 113.

According to an embodiment, the nano optical lens array 130 may include a plurality of nano structures arranged according to a certain pattern. The plurality of nano structures may be distributed to the first unit corresponding area 131, the second unit corresponding area 132, the third unit corresponding area 133, and the fourth unit corresponding area 134 which form the nano optical lens array 130. Each of the first unit corresponding area 131, the second unit corresponding area 132, the third unit corresponding area 133, and the fourth unit corresponding area 134 may include at least one nano structure NP.

The number of nano structures NP arranged in the first unit corresponding area 131 and the fourth unit corresponding area 134 may be greater than the number of nano structures NP arranged in the third unit corresponding area 133. The number of nano structures NP arranged in the second unit corresponding area 132 may be greater than the number of nano structures NP arranged in the first unit corresponding area 131 and the fourth unit corresponding area 134. However, the disclosure is not limited thereto.

The arrangement of at least one nano structure NP arranged in the first unit corresponding area 131 may have symmetry with respect to the first direction (X direction) as an axis of symmetry, and the arrangement of at least one nano structure NP arranged in the fourth unit corresponding area 134 may have 1-fold symmetry with respect to the second direction (Y direction) as an axis of symmetry. As illustrated in FIG. 5, the arrangement of at least one nano structure NP arranged in the first unit corresponding area 131 and the arrangement of at least one nano structure NP arranged in the fourth unit corresponding area 134 may be 90 degrees-rotationally symmetrical with each other. However, the disclosure is not limited thereto.

The arrangement of at least one nano structure NP arranged in the second unit corresponding area 132 may have 2-fold symmetry with respect to the first direction (X direction) and the second direction (Y direction) as an axis of symmetry.

The nano optical lens array 130 may form a green light-condensing area, a red light-condensing area, and a blue light-condensing area. In addition, the incident light transmitted through the nano optical lens array 130 may form a phase profile condensed onto the central light-sensing cell and each of the peripheral light-sensing cells. Hereinafter, various examples of condensing areas formed by the arrangement of the nano structures NP of the nano optical lens array 130 are described.

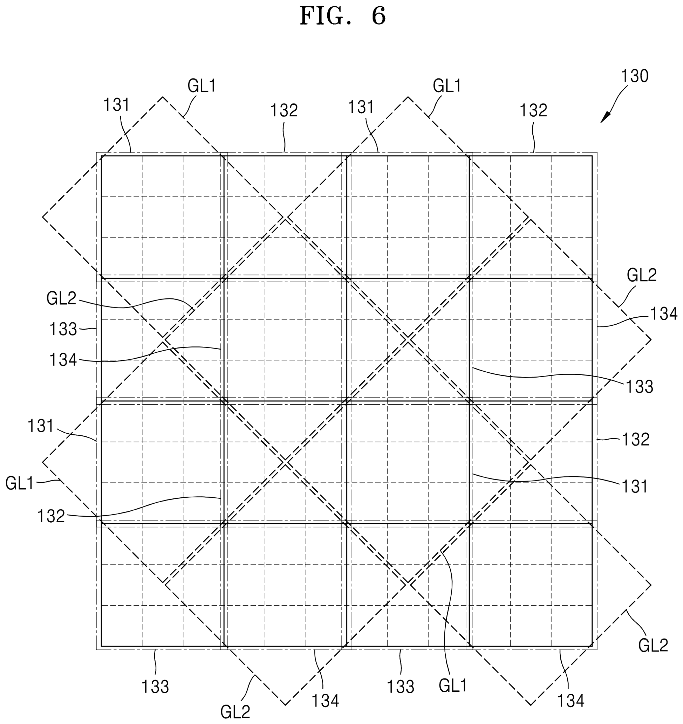

FIG. 6 is a plan view illustrating green light-condensing areas formed by a nano optical lens array of a pixel array of an image sensor according to an embodiment.

Referring to FIGS. 4 and 6, the nano optical lens array 130 may include a first green light-condensing area GL1 and a second green light-condensing area GL2. The first green light-condensing area GL1 may condense light of the first wavelength band from the incident light onto the first unit light-sensing cell 111 corresponding to the first unit corresponding area 131, and the second green light-condensing area GL2 may condense light of the first wavelength band from the incident light onto the fourth unit light-sensing cell 114 corresponding to the fourth unit corresponding area 134. The size of the first green light-condensing area GL1 may be greater than the size of the first unit light-sensing cell 111, and the size of the second green light-condensing area GL2 may be greater than the size of the second unit light-sensing cell 112.

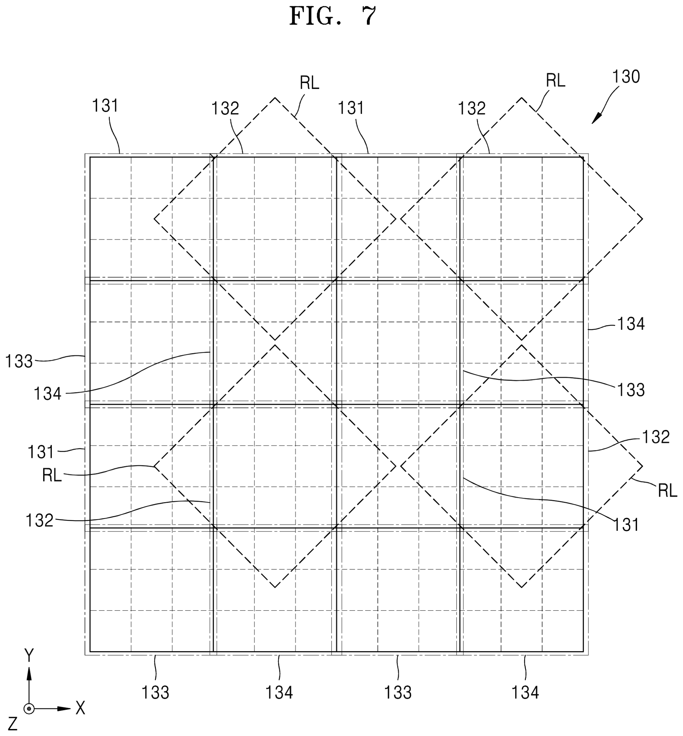

FIG. 7 is a plan view illustrating red light-condensing areas formed by a nano optical lens array of a pixel array of an image sensor according to an embodiment.

Referring to FIGS. 4 and 7, the nano optical lens array 130 may include a red light-condensing area RL. The red light-condensing area RL may condense light of the second wavelength band of the incident light onto the second unit light-sensing cell 112 corresponding to the second unit corresponding area 132. The size of the red light-condensing area RL may be greater than the size of the second unit light-sensing cell 112.

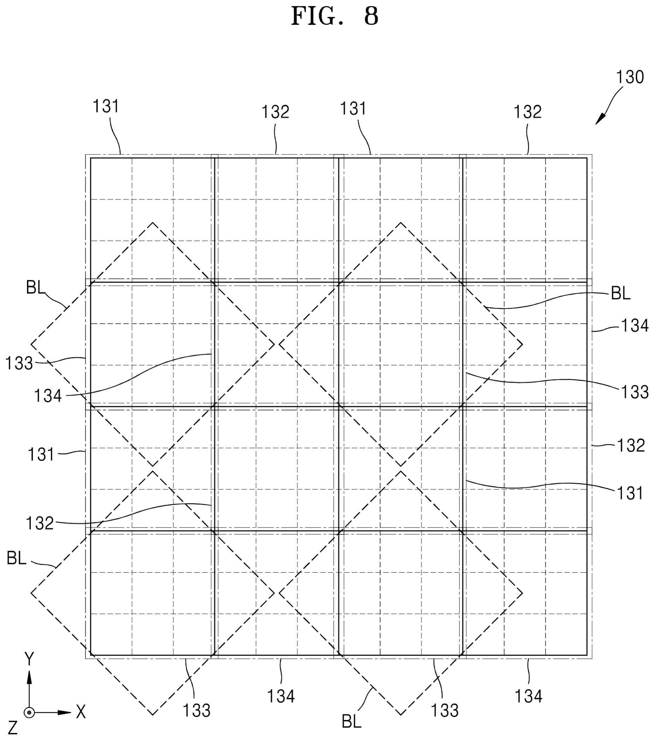

FIG. 8 is a plan view illustrating blue light-condensing areas formed by a nano optical lens array of a pixel array of an image sensor according to an embodiment.

Referring to FIGS. 4 and 8, the nano optical lens array 130 may include a blue light-condensing area BL. The blue light-condensing area BL may condense light of the third wavelength band of the incident light onto the third unit light-sensing cell 113 corresponding to the third unit corresponding area 133. The size of the blue light-condensing area BL may be greater than the size of the third unit light-sensing cell 113.

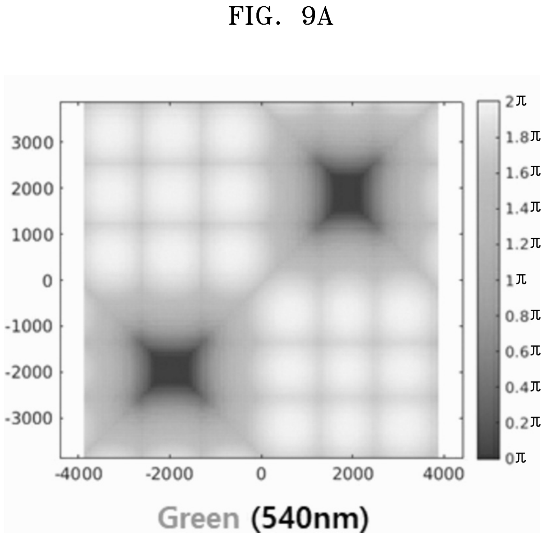

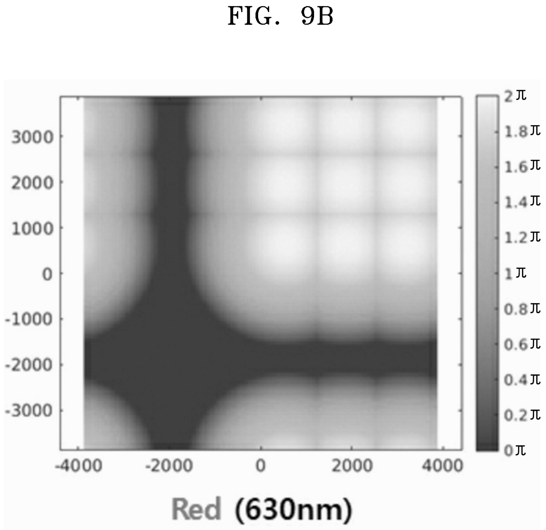

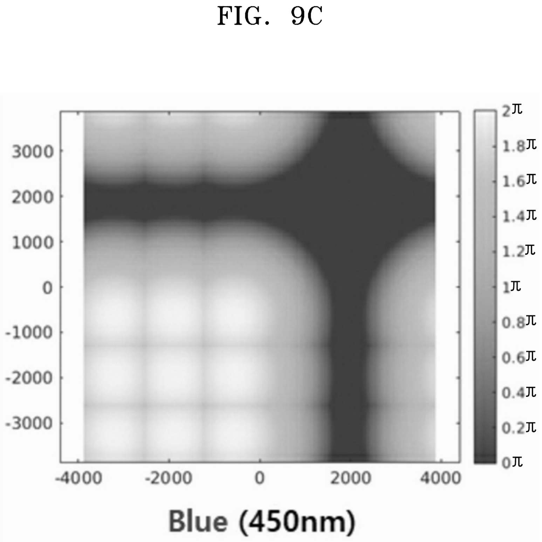

FIGS. 9A, 9B and 9C are diagrams illustrating target phase profiles of the nano optical lens array of FIG. 5. The focal length was set to be 4 µm, and the pitch of the light-sensing cell was set to be 0.64 µm. The phase profiles of the nano optical lens array are further described in relation to FIG. 5.

Referring to FIG. 5 and FIG. 9A, the nano optical lens array 130 may form a phase profile in which the green light is color-separated and condensed onto the central light-sensing cell 111a and the peripheral light-sensing cells 111b of the first unit light-sensing cell 111 and the central light-sensing cell 114a and the peripheral light-sensing cells 114b of the fourth unit light-sensing cell 114. In the first unit corresponding area 131, the green light transmitted through the nano optical lens array 130 may have a phase delay peak value (2π) at the center of the central corresponding area 131a corresponding to the central light-sensing cell 111a and a phase delay value decreasing away from the center and may have a phase delay peak value (2π) at the center of each peripheral corresponding area 131b corresponding to the peripheral light-sensing cell 111b and a phase delay value decreasing away from the center.

Similarly, in the fourth unit corresponding area 134, the green light transmitted through the nano optical lens array 130 may have a phase delay peak value (2π) at the center of the central corresponding area 134a corresponding to the central light-sensing cell 114a and a phase profile in which a phase delay value decreases away from the center and may have a phase delay peak value (2π) at the center of each peripheral corresponding area 134b corresponding to the peripheral light-sensing cell 114b and a phase delay value decreasing away from the center.

Referring to FIG. 9B, the nano optical lens array 130 may form a phase profile in which red light is color-separated and condensed onto the central light-sensing cell 112a and the peripheral light-sensing cells 112b of the second unit light-sensing cell 112. In the second unit corresponding area 132, the red light transmitted through the nano optical lens array 130 may have a phase delay peak value (2π) at the center of the central corresponding area 132a corresponding to the central light-sensing cell 112a and a phase delay value decreasing away from the center and may have a phase delay peak value (2π) at the center of each peripheral corresponding area 132b corresponding to the peripheral light-sensing cell 112b and a phase delay value decreasing away from the center.

Referring to FIG. 9C, the nano optical lens array 130 may form a phase profile in which blue light is condensed onto the central light-sensing cell 113a and the peripheral light-sensing cells 113b of the third unit light-sensing cell 113. In the third unit corresponding area 133, the blue light transmitted through the nano optical lens array 130 may have a phase delay peak value (2π) at the center of the central corresponding area 133a corresponding to the central light-sensing cell 113a and a phase delay value decreasing away from the center and may have a phase delay peak value (2π) at the center of each peripheral corresponding area 133b corresponding to the peripheral light-sensing cell 113b and a phase delay value decreasing away from the center.

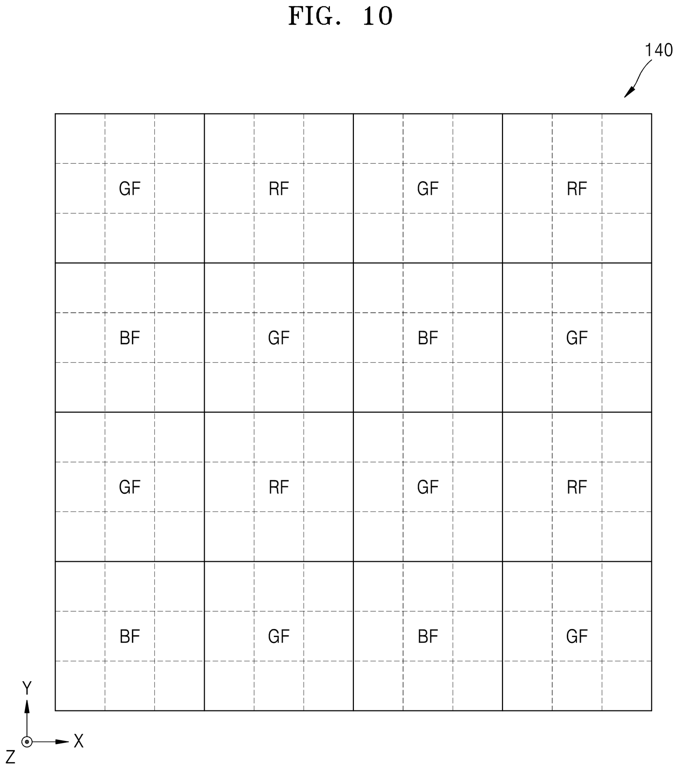

FIG. 10 is a plan view of a color filter layer of a pixel array of an image sensor according to an embodiment.

Referring to FIG. 10, the color filter layer 140 may include a plurality of color filters transmitting light of a particular wavelength band and absorbing light of other wavelength bands. For example, the color filter layer 140 may include the green color filter GF configured to transmit light of the first wavelength band and absorb light of other wavelength bands, the red color filter RF configured to transmit light of the second wavelength band and absorb light of other wavelength bands, and the blue color filter BF configured to transmit light of the third wavelength band and absorb light of other wavelength bands.

Referring to FIG. 4, the green color filter GF may be arranged on the first unit light-sensing cell 111 and the fourth unit light-sensing cell 114, the red color filter RF may be arranged on the second unit light-sensing cell 112, and the blue color filter BF may be arranged on the third unit light-sensing cell 113. As incident light is color-separated considerably by the nano optical lens array 130, even in an example case in which the color filter layer 140 is used, the absorption loss due to the color filter layer 140 may be small. In addition, as the nano optical lens array 130 and the color filter layer 140 are used together, the color purity may be improved. The color filter layer 140 may be omitted.

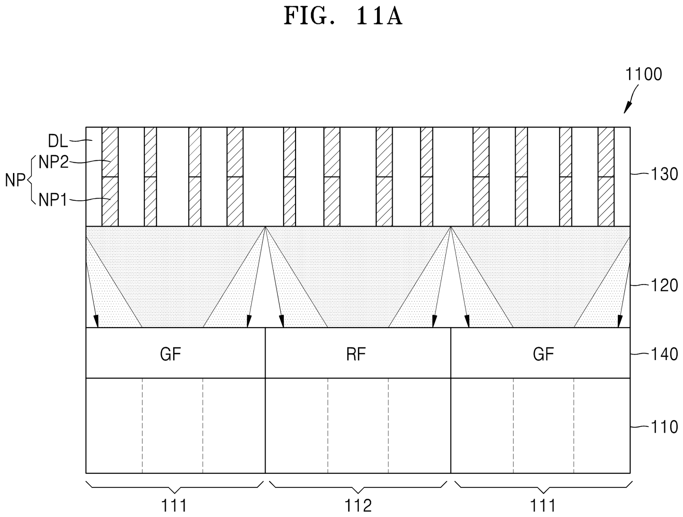

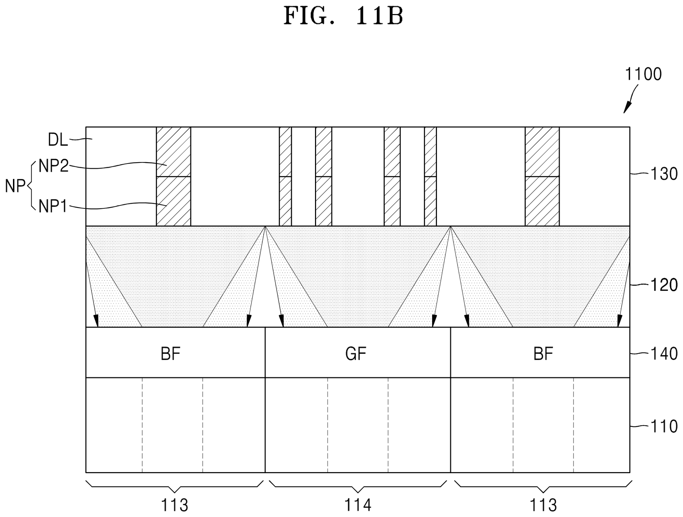

FIG. 11A is a cross-sectional view of a pixel array of an image sensor taken along line A-A' of FIG. 2, according to another embodiment, and FIG. 11B is a cross-sectional view of a pixel array of an image sensor taken along line B-B' of FIG. 2, according to another embodiment. Embodiments are to be described focusing on the differences by referring to FIG. 3.

Referring to FIGS. 11A and 11B, the nano optical lens array 130 may be provided to perform only the light-condensing function but not the color separation function, compared to the embodiment of FIG. 3. To this end, the plurality of nano structures NP may be included in the nano optical lens array 130 in various manners. For example, the plurality of nano structures NP may be arranged to change a phase of light transmitted through the nano optical lens array 130 according to a location of a phase of the nano optical lens array 130. The phase profile of the transmitted light, which is implemented by the nano optical lens array 130 may be determined according to the size (e.g., width or diameter), shape, height of a cross-section of each of the nano structures NP, an arrangement cycle (or pitch) of the plurality of nano structures NP, and an arrangement pattern of the plurality of nano structures NP. Moreover, the movement of light transmitted through the nano optical lens array 130 may be determined according to the phase profile of the transmitted light. The nano optical lens array 130 may be provided such that the incident light is condensed onto each of the light-sensing cells (111, 112, 113, and 114). In this case, the size (or surface area) of the unit corresponding area of the nano optical lens array 130 may be identical to the size of each light-sensing cell. The incident light transmitted through the nano optical lens array 130 may be condensed onto the central light-sensing cell and the plurality of peripheral light-sensing cells surrounding the central light-sensing cell of each unit light-sensing cell (111, 112, 113, and 114).

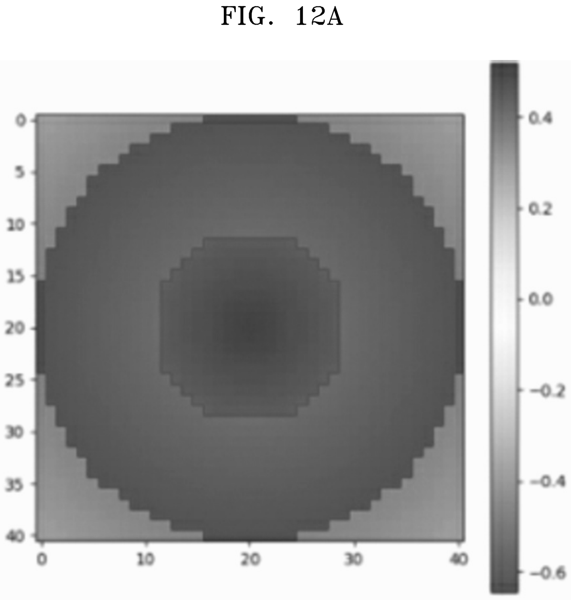

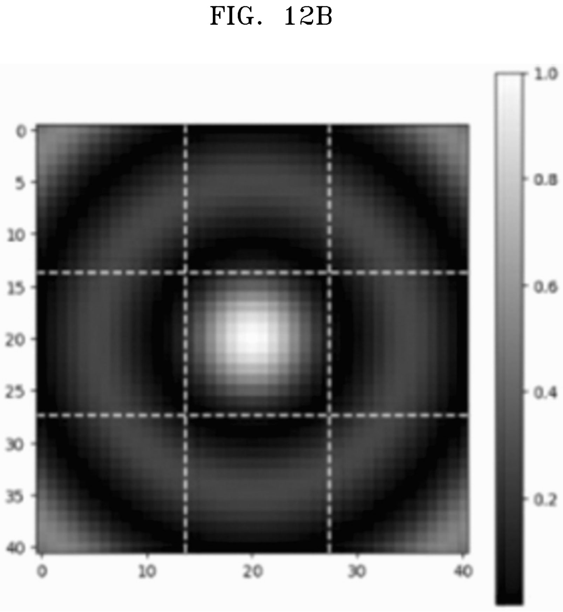

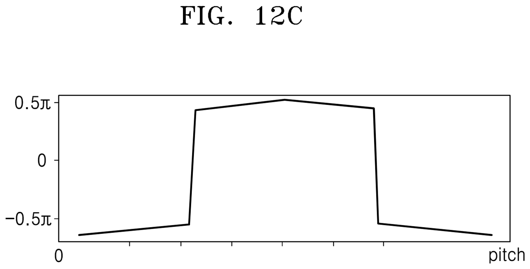

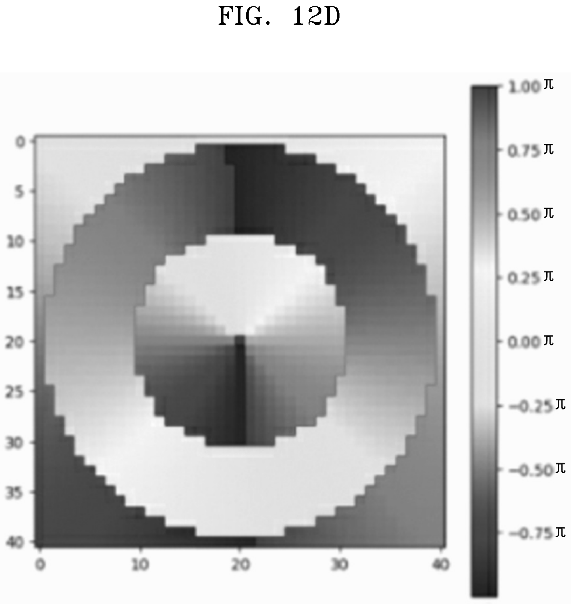

FIGS. 12A, 12B, 12C and 12D are diagrams showing signal intensities at a unit light-sensing cell and target phase profiles of a nano optical lens array of the pixel array of FIGS. 11A and 11B.

Referring to FIGS. 12A, 12B, 12C and 12D, the nano optical lens array 130 performing the light-condensing function may be provided to form a phase profile in the form of Bessel function.

FIGS. 12A is a diagram showing formation of a phase profile in the form of zero-order Bessel function by the nano optical lens array 130, FIGS. 12B is diagram showing signal intensity at the unit light-sensing cell according to the phase profile of FIGS. 12A, and FIGS. 12C is a cross-sectional view of the phase profile of FIGS. 12A shown from one direction (e.g., first direction (X direction)) of the nano optical lens array 130.

Referring to FIGS. 12A, 12B and 12C, in an example case in which the nano optical lens array 130 form a phase profile in the form of zero-order Bessel function, the incident light is condensed not only onto the central light-sensing cell but also onto the peripheral light-sensing cells in the unit light-sensing cell, and the signal intensity at the unit light-sensing cell may be in the form of Bessel function.

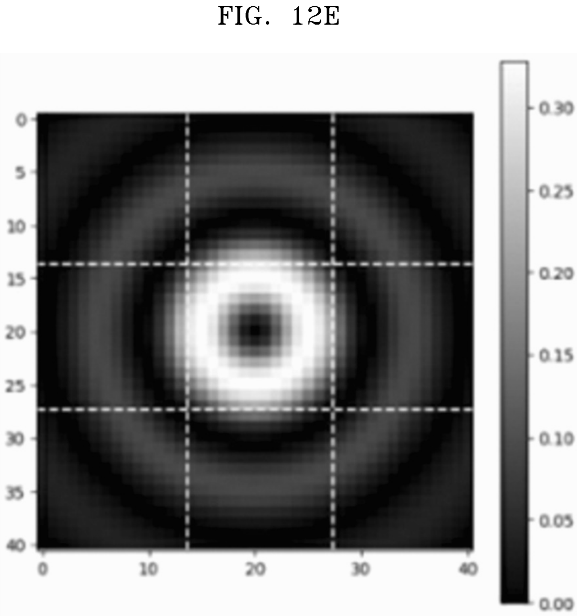

FIG. 12D is a diagram showing formation of a phase profile in the form of first order Bessel function by the nano optical lens array 130, and FIG. 12E is a diagram showing signal intensity at the unit light-sensing cell according to the phase profile illustrated in FIG. 12 D. Referring to FIGS. 12D and 12E, in an example case in which the nano optical lens array 130 form a phase profile in the form of first order Bessel function, the incident light is condensed onto the central light-sensing cell in the unit light-sensing cell and also evenly condensed onto the peripheral light-sensing cell 111b in a form having a greater radius than the condensing form on the central light-sensing cell.

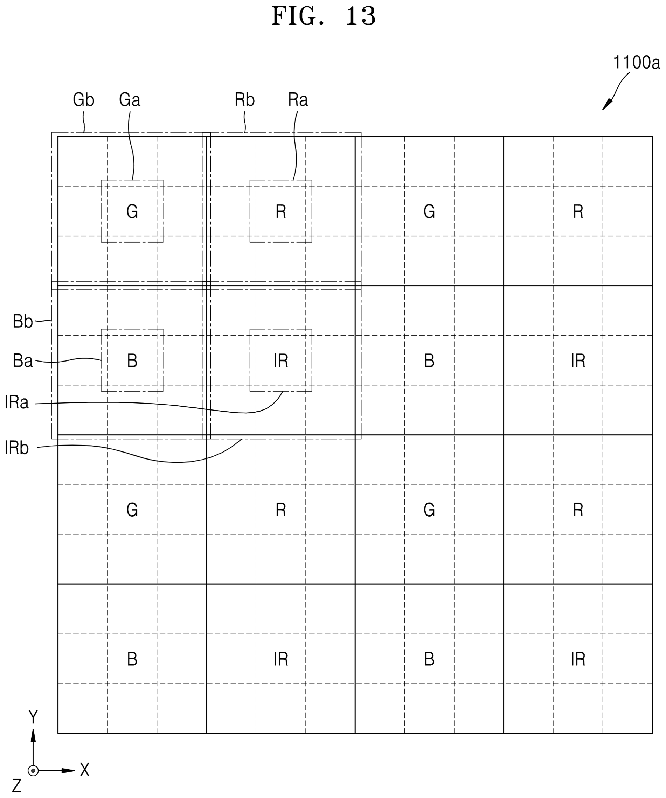

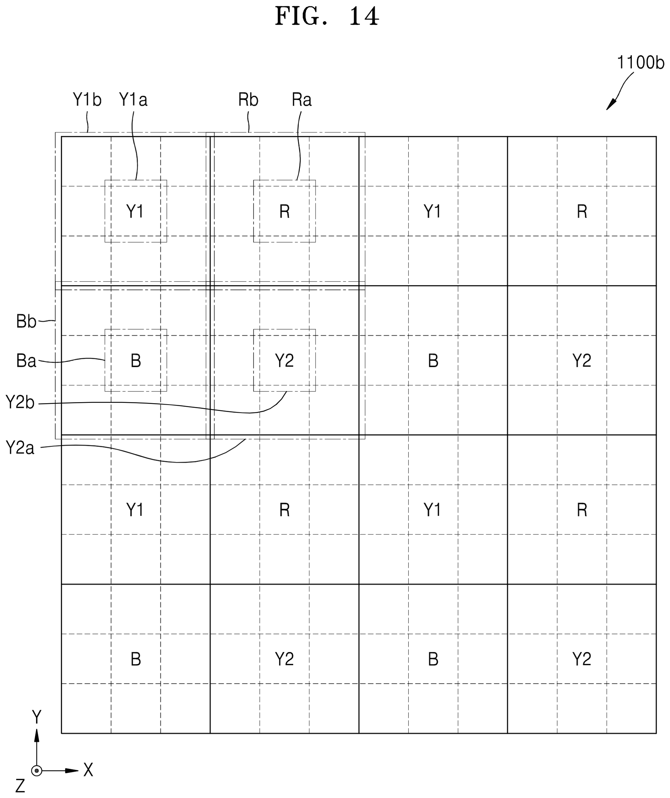

FIGS. 13 and 14 are each a plan view illustrating an example of a pixel arrangement of a pixel array of an image sensor according to another embodiment. In the description, for the sake of brevity, only the differences from FIG. 2 may be highlighted.

Referring to FIG. 13, a pixel array 1100a may include a plurality of unit pixel structures arranged in a 2D manner, and a plurality of unit pixels may have structure in which a green pixel G, a red pixel R, a blue pixel B, and an infrared pixel IR are arranged in a 2x2 array.

The green pixel G, the red pixel R, the blue pixel B, and the infrared pixel IR may each include a plurality of pixels arranged in a 3x3 array. The green pixel G, the red pixel R, the blue pixel B, and the infrared pixel IR may each include a central pixel provided at the center and a plurality of peripheral pixels surrounding the central pixel.

For example, as illustrated in FIG. 13, a green central pixel Ga may be provided at the center of the green pixel G, and a plurality of green peripheral pixels Gb may surround the green central pixel Ga. Similarly, a red central pixel Ra may be provided at the center of the red pixel R, and a plurality of red peripheral pixels Rb may surround the red central pixel Ra. A blue central pixel Ba may be provided at the center of the blue pixel B, and a plurality of blue peripheral pixels Bb may surround the blue central pixel Ba. An infrared central pixel IRa may be provided at the center of the infrared pixel IR, and a plurality of infrared peripheral pixels IRb may surround the infrared central pixel IRa.

Referring to FIG. 14, a pixel array 1100b may include a plurality of unit pixel structures arranged in a 2D manner, and a plurality of unit pixels may have structure in which a first yellow pixel Y1, a red pixel R, a blue pixel B, and a second yellow pixel Y2 are arranged in a 2x2 array.

The first yellow pixel Y1, the red pixel R, the blue pixel B, and the second yellow pixel Y2 may each include a plurality of pixels arranged in a 3x3 array. The first yellow pixel Y1, the red pixel R, the blue pixel B, and the second yellow pixel Y2 may each include a central pixel provided at the center and a plurality of peripheral pixels surrounding the central pixel.

For example, as illustrated in FIG. 14, a first yellow central pixel Y1a may be provided at the center of the first yellow pixel Y1, and a plurality of first yellow peripheral pixels Y1b may surround the first yellow central pixel Y1a. Similarly, a red central pixel Ra may be provided at the center of the red pixel R, and a plurality of red peripheral pixels Rb may surround the red central pixel Ra. A blue central pixel Ba may be provided at the center of the blue pixel B, and a plurality of blue peripheral pixels Bb may surround the blue central pixel Ba. A second yellow central pixel Y2a may be provided at the center of the second yellow pixel Y2, and a plurality of second yellow peripheral pixels Y2b may surround the second yellow central pixel Y2a.

The description provided in relation to FIGS. 2 to 12 may also be applied to the pixel array 1100a of FIG. 13 and the pixel array 1100b of FIG. 14.

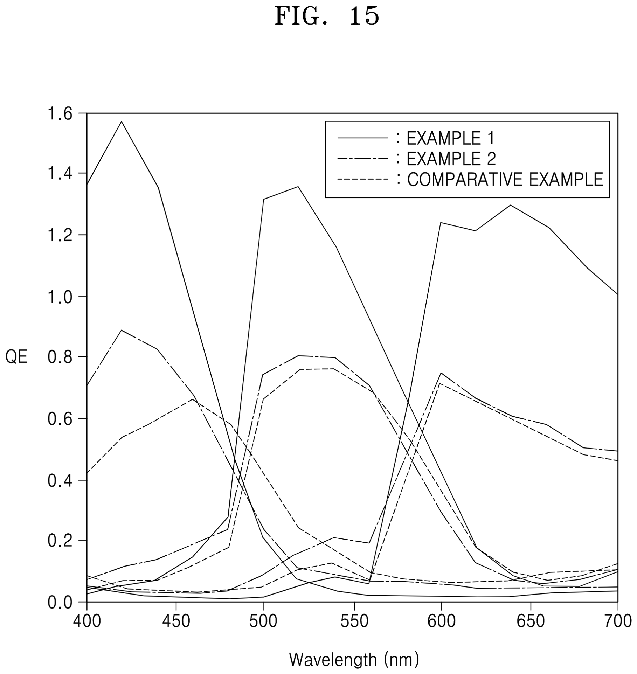

FIG. 15 is a diagram showing graphs for comparing color separation performance between image sensors according to some embodiments and an image sensor according to a comparative example. In FIG. 15, the solid line represents quantum efficiency (QE) at the central light-sensing cell of the image sensor according to an embodiment (Example 1), the dashed dotted line represents QE at the peripheral light-sensing cell of the image sensor according to an embodiment (Example 2), and the dotted line represents QE at the light-sensing cell of the image sensor according to a comparative example (Comparative Example).

Referring to FIG. 15, when comparing the image sensor 1000 including the nano optical lens array 130 according to the examples with the image sensor according to the comparative example, the QE increased about 48 %at the central light-sensing cell and increased about 5 % at the peripheral light-sensing cells. According to the examples, by applying the nano optical lens array 130 forming the phase profile described above to the image sensor 1000, light may be condensed onto the peripheral light-sensing cells while increasing the amount of light condensed onto the central light-sensing cell.

As such, by designing the phase profile by the nano optical lens array 130, the amount of light condensed onto the central light-sensing cell and the peripheral light-sensing cells may be controlled, and the degree of freedom of tuning in the dynamic range of the central light-sensing cell and the peripheral light-sensing cells may be increased.

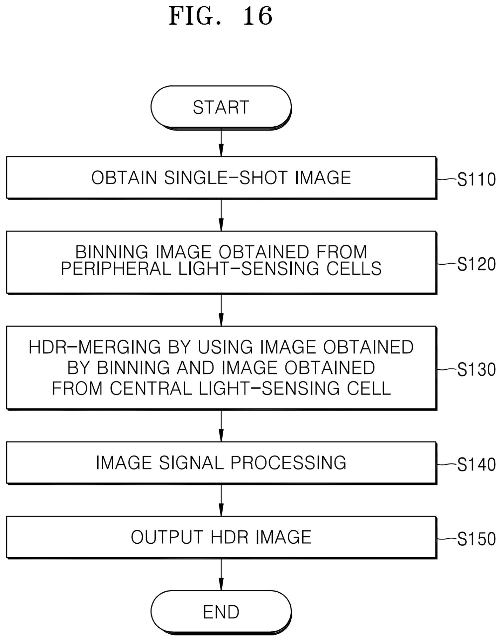

FIG. 16 is a block diagram illustrating an HDR drive process of an image sensor according to an embodiment.

Referring to FIG. 16, in operation S110, the HDR drive process may include obtaining a single-shot image. For example, the single-shot image may be generated based on signals from the central light-sensing cell and each of the peripheral light-sensing cells surrounding the central light-sensing cell of the image sensor. For example, the single-shot image may be generated by obtaining signals from the central light-sensing cell and each of the peripheral light-sensing cells surrounding the central light-sensing cell of the image sensor. In operation S120, the HDR drive process may include binning images obtained from the peripheral light-sensing cells in the single-shot image. In operation S130, after binning images obtained from the peripheral light-sensing cells, the HDR drive process may include performing HDR merge using a image obtained through the binning and a image obtained from the central light-sensing cell in the single-shot image. For example, the HDR merge weight may be applied to each image. In operation S140, the HDR drive process may include image signal processing on the images after the HDR merge. For example, the image signal processing may include, but is not limited to, demosaic processing, an auto white balance (AWB) correction, color correction matrix (CCM), or gamma correction may be performed. In operation S150, the HDR drive process may include outputting the HDR image after the image signal processing is completed. The signal processed image may be output as a HDR image.

The image sensor 1000 according to an embodiment may constitute a camera module along with a module lens having various functions and may be used in various electronic devices.

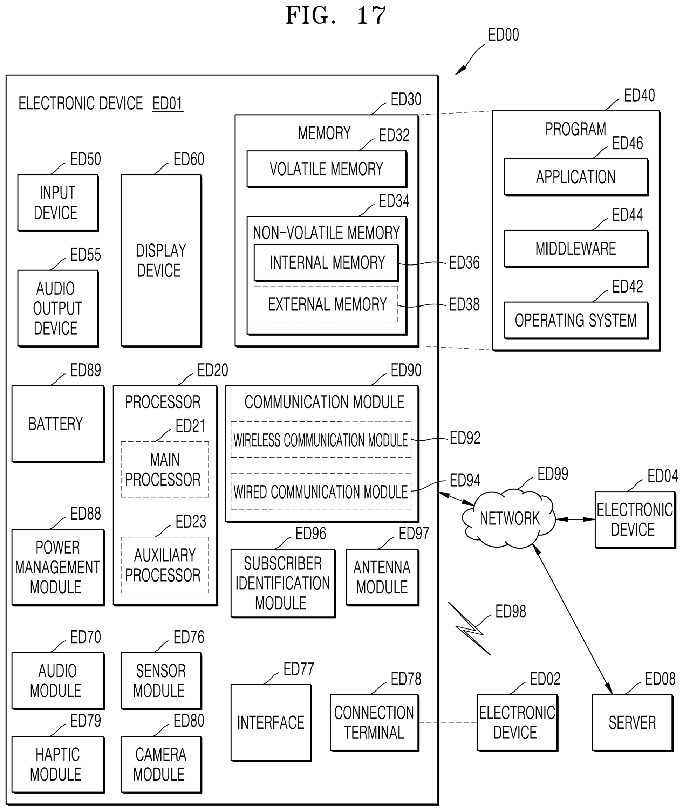

FIG. 17 is a block diagram illustrating an example of an electronic device ED01 including the image sensor 1000.

Referring to FIG. 17, in a network environment ED00, an electronic device ED01 may communicate with another electronic device ED02 through a first network ED98 (a short-range wireless communication network and the like), or communicate with another electronic device ED04 and/or a server ED08 through a second network ED99 (a long-range wireless communication network and the like). The electronic device ED01 may communicate with the electronic device ED04 through the server ED08. The electronic device ED01 may include a processor ED20, a memory ED30, an input device ED50, an audio output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic device ED01, some (the display device ED60, and the like) of constituent elements may be omitted or other constituent elements may be added. Some of the foregoing components may be implemented as a single integrated circuit. For example, the sensor module ED76 (a fingerprint sensor, an iris sensor, an illuminance sensor, and the like) may be implemented by being embedded in the display device ED60 (a display, and the like).

The processor ED20 may control one or a plurality of other constituent elements (hardware and software constituent elements, and the like) of the electronic device ED01 connected to the processor ED20 by executing software (a program ED40, and the like), and perform various data processing or calculations. As part of the data processing or calculations, the processor ED20 may load, in a volatile memory ED32, commands and/or data received from other constituent elements (the sensor module ED76, the communication module ED90, and the like), process the command and/or data stored in the volatile memory ED32, and store result data in a non-volatile memory ED34. The processor ED20 may include a main processor ED21 (a central processing unit, an application processor, and the like) and an auxiliary processor ED23 (a graphics processing unit, an image signal processor, a sensor hub processor, a communication processor, and the like) that is operable independently of or together with the main processor ED21. The auxiliary processor ED23 may use less power than the main processor ED21 and may perform a specialized function.

In an example case in which the main processor ED21 is in an inactive state (sleep state), or in an example case in which the main processor ED21 is in an active state (application execution state), the auxiliary processor ED23 may control functions and/or states related to some constituent elements (the display device ED60, the sensor module ED76, the communication module ED90, and the like) of the constituent elements of the electronic device ED01. The auxiliary processor ED23 (an image signal processor, a communication processor, and the like) may be implemented as a part of functionally related other constituent elements (the camera module ED80, the communication module ED90, and the like).

The memory ED30 may store various data needed by the constituent elements (the processor ED20, the sensor module ED76, and the like) of the electronic device ED01. The data may include, for example, software (the program ED40, and the like) and input data and/or output data about commands related thereto. The memory ED30 may include the volatile memory ED32 and/or the non-volatile memory ED34.

The program ED40 may be stored in the memory ED30 as software, and may include an operating system ED42, middleware ED44, and/or an application ED46.

The input device ED50 may receive commands and/or data to be used for constituent elements (the processor ED20, and the like) of the electronic device ED01, from the outside (a user, and the like) of the electronic device ED01. The input device ED50 may include a microphone, a mouse, a keyboard, and/or a digital pen (a stylus pen, and the like).

The audio output device ED55 may output an audio signal to the outside of the electronic device ED01. The audio output device ED55 may include a speaker and/or a receiver. The speaker may be used for general purposes such as multimedia play or playback, and the receiver may be used to receive incoming calls. The receiver may be integrated as a part of the speaker or implemented independently as a separate device.

The display device ED60 may visually provide information to the outside of the electronic device ED01. The display device ED60 may include a display, a hologram device, or a projector, and a control circuit to control a corresponding device. The display device ED60 may include a touch circuitry set to detect a touch and/or a sensor circuit (a pressure sensor, and the like) set to measure the strength of a force generated by the touch.

The audio module ED70 may convert sound into electric signals or reversely electric signals into sound. The audio module ED70 may obtain sound through the input device ED50, or output sound through a speaker and/or a headphone of another electronic device (the electronic device ED02, and the like) connected to the audio output device ED55 and/or the electronic device ED01 in a wired or wireless manner.

The sensor module ED76 may detect an operation state (power, temperature, and the like) of the electronic device ED01, or an external environment state (a user state, and the like), and generate an electric signal and/or a data value corresponding to a detected state. The sensor module ED76 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface ED77 may support one or a plurality of specified protocols used for the electronic device ED01 to be connected to another electronic device (the electronic device ED02, and the like) in a wired or wireless manner. The interface ED77 may include a high definition multimedia interface (HDMI), a universal serial bus (USB) interface, an SD card interface, and/or an audio interface.

A connection terminal ED78 may include a connector for the electronic device ED01 to be physically connected to another electronic device (the electronic device ED02, and the like). The connection terminal ED78 may include an HDMI connector, a USB connector, an SD card connector, and/or an audio connector (a headphone connector, and the like).

The haptic module ED79 may convert electric signals into mechanical stimuli (vibrations, movements, and the like) or electric stimuli that are perceivable by a user through tactile or motor sensations. The haptic module ED79 may include a motor, a piezoelectric device, and/or an electric stimulation device.

The camera module ED80 may capture a still image and a video. The camera module ED80 may include a lens assembly including one or a plurality of lenses, the image sensor 1000 of FIG. 1, image signal processors, and/or flashes. The lens assembly included in the camera module ED80 may collect light emitted from a subject for image capturing.

The power management module ED88 may manage power supplied to the electronic device ED01. The power management module ED88 may be implemented as a part of a power management integrated circuit (PMIC).

The battery ED89 may supply power to the constituent elements of the electronic device ED01. The battery ED89 may include non-rechargeable primary cells, rechargeable secondary cells, and/or fuel cells.

The communication module ED90 may establish a wired communication channel and/or a wireless communication channel between the electronic device ED01 and another electronic device (the electronic device ED02, the electronic device ED04, the server ED08, and the like), and support a communication through an established communication channel. The communication module ED90 may be operated independent of the processor ED20 (the application processor, and the like), and may include one or a plurality of communication processors supporting a wired communication and/or a wireless communication. The communication module ED90 may include a wireless communication module ED92 (a cellular communication module, a short-range wireless communication module, a global navigation satellite system (GNSS) communication module, and the like), and/or a wired communication module ED94 (a local area network (LAN) communication module, a power line communication module, and the like). Among the above communication modules, a corresponding communication module may communicate with another electronic device through the first network ED98 (a short-range communication network such as Bluetooth, WiFi Direct, or infrared data association (IrDA)) or the second network ED99 (a long-range communication network such as a cellular network, the Internet, or a computer network (LAN, WAN, and the like)). Such various types of communication modules may be integrated into one component (e.g., a single chip, etc.), or may be implemented as a plurality of separate components (e.g., multiple chips). The wireless communication module ED92 may verify and authenticate the electronic device ED01 in a communication network such as the first network ED98 and/or the second network ED99 by using subscriber information (an international mobile subscriber identifier (IMSI), and the like) stored in the subscriber identification module ED96.

The antenna module ED97 may transmit signals and/or power to the outside (another electronic device, and the like) or receive signals and/or power from the outside. The antenna may comprise a radiator consisting of conductive patterns formed on a substrate (e.g., a printed circuit board (PCB), etc.) The antenna module ED97 may include one or a plurality of antennas. In an example case in which the antenna module ED97 includes a plurality of antennas, the communication module ED90 may select, from among the antennas, an appropriate antenna for a communication method used in a communication network such as the first network ED98 and/or the second network ED99. Signals and/or power may be transmitted or received between the communication module ED90 and another electronic device through the selected antenna. Other parts (an RFIC, and the like) than the antenna may be included as a part of the antenna module ED97.

Some of the components may be connected and exchange signals (e.g., commands, data, etc.) with each other through communication methods among peripheral devices (e.g., a bus, general purpose input and output (GPIO), serial peripheral interphase (SPI), mobile industry processor interface (MIPI), etc.)

The command or data may be transmitted or received between the electronic device ED01 and the external electronic device ED04 through the server ED08 connected to the second network ED99. The electronic devices ED02 and ED04 may be of a type that is the same as or different from the electronic device ED01. All or a part of operations executed in the electronic device ED01 may be executed in one or a plurality of the electronic devices (ED02, ED04, and ED08). In an example case in which the electronic device ED01 needs to perform a function or service, the electronic device ED01 may request one or a plurality of electronic devices to perform part of the whole of the function or service, instead of performing the function or service. The one or a plurality of the electronic devices receiving the request may perform additional function or service related to the request, and transmit a result of the performance to the electronic device ED01. To this end, cloud computing, distributed computing, and/or client-server computing technologies may be used.

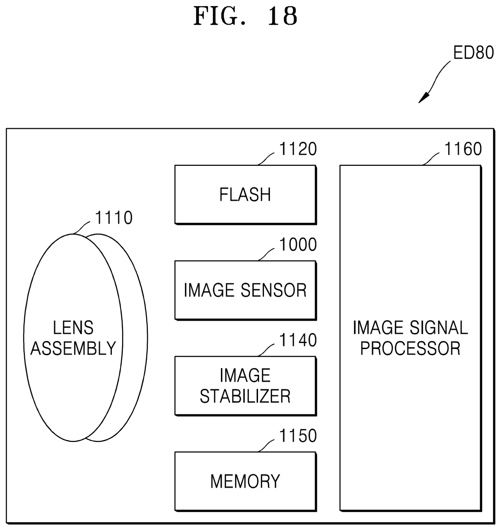

FIG. 18 is a block diagram illustrating an example of the camera module ED80 included in the electronic device ED01 of FIG. 17.

Referring to FIG. 18, the camera module ED80 may include a lens assembly 1110, a flash 1120, the image sensor 1000, an image stabilizer 1140, a memory 1150 (e.g., a buffer memory, etc.), and/or an image signal processor 1160. The lens assembly 1110 may collect light emitted from a subject for image capturing. The camera module ED80 may include a plurality of lens assemblies 1110, and in this case, the camera module ED80 may include a dual camera, a 360 degrees camera, or a spherical camera. Some of the lens assemblies 1110 may have the same lens attributes (a viewing angle, a focal length, auto focus, F Number, optical zoom, and the like), or different lens attributes. The lens assembly 1110 may include a wide angle lens or a telescopic lens.

The flash 1120 may emit light used to reinforce light emitted or reflected from a subject. The flash 1120 may emit visible light or infrared light. The flash 1120 may include one or a plurality of light-emitting diodes (a red-green-blue (RGB) LED, a white LED, an infrared LED, an ultraviolet LED, and the like), and/or a xenon lamp. The image sensor 1000 may include the image sensor of FIG. 1, and convert light emitted or reflected from the subject and transmitted through the lens assembly 1110 into electrical signals, thereby obtaining an image corresponding to the subject.

The image stabilizer 1140 may move, in response to a movement of the camera module ED80 or an electronic device ED01 including the same, one or a plurality of lenses included in the lens assembly 1110 or the image sensor 1000 in a particular direction or may compensate a negative effect due to the movement by controlling (adjusting a read-out timing, and the like) the movement characteristics of the image sensor 1000. The image stabilizer 1140 may detect a movement of the camera module ED80 or the electronic device ED01 by using a gyro sensor or an acceleration sensor arranged inside or outside the camera module ED80. The image stabilizer 1140 may be implemented in an optical form.

The memory 1150 may store a part or entire data of an image obtained through the image sensor 1000 for a subsequent image processing operation. In an example case in which a plurality of images are obtained at high speed, only low resolution images are displayed while the obtained original data (Bayer-patterned data, high resolution data, and the like) is stored in the memory 1150. Then, the memory 1150 may be used to transmit the original data of a selected (user selection, and the like) image to the image signal processor 1160. The memory 1150 may be incorporated into the memory ED30 of the electronic device ED01, or configured to be an independently operated separate memory.

The image signal processor 1160 may obtain an image by using electric signals output from the image sensor 1000. For example, the image signal processor 1160 may directly perform a part of the image processing illustrated in FIG. 23 to 26 in association with the image sensor 1000. In addition, the image signal processor 1160 may request image data of particular format from the image sensor 1000 according to a required image data format.

Moreover, the image signal processor 1160 may perform additional image processing on the image obtained through the image sensor 1000 or the image data stored in the memory 1150. The image processing may include depth map generation, three-dimensional modeling, panorama generation, feature point extraction, image synthesis, and/or image compensation (noise reduction, resolution adjustment, brightness adjustment, blurring, sharpening, softening, and the like). The image signal processor 1160 may perform control (exposure time control, or read-out timing control, and the like) on constituent elements (the image sensor 1000, and the like) included in the camera module ED80.

The image processed by the image signal processor 1160 may be stored again in the memory 1150 for additional processing or provided to external constituent elements (the memory ED30, the display device ED60, the electronic device ED02, the electronic device ED04, the server ED08, and the like) of the camera module ED80. The image signal processor 1160 may be incorporated into the processor ED20, or configured to be a separate processor operated independently of the processor ED20. In an example case in which the image signal processor 1160 is configured by a separate processor from the processor ED20, the image processed by the image signal processor 1160 may undergo additional image processing by the processor ED20 and then displayed through the display device ED60.

The image signal processor 1160 may receive two output signals independently from adjacent light-sensing cells in each pixel or subpixel of the image sensor 1000 and generate an automatic focus signal from a difference between the two output signals. The image signal processor 1160 may control the lens assembly 1110 to accurately apply the focus of the lens assembly 1110 on the surface of the image sensor 1000 based on the automatic focus signal.

The electronic device ED01 may further include one or more camera modules that have different characteristics or functions from each other. The camera module may include a component similar to the camera module ED80 of FIG. 28, and an image sensor provided therein may be implemented as a charged coupled device (CCD) sensor or complementary metal oxide semiconductor (CMOS) sensor any may include one or more image sensors selected from image sensors having different properties, such an RGB sensor, a black and white (BW) sensor, an infrared (IR) sensor, and an ultraviolet (UV) sensor. In this case, one of the camera modules ED80 may be a wide angle camera, and another may be a telescopic camera. Similarly, one of the camera modules ED80 may be a front side camera, and another may be a read side camera.

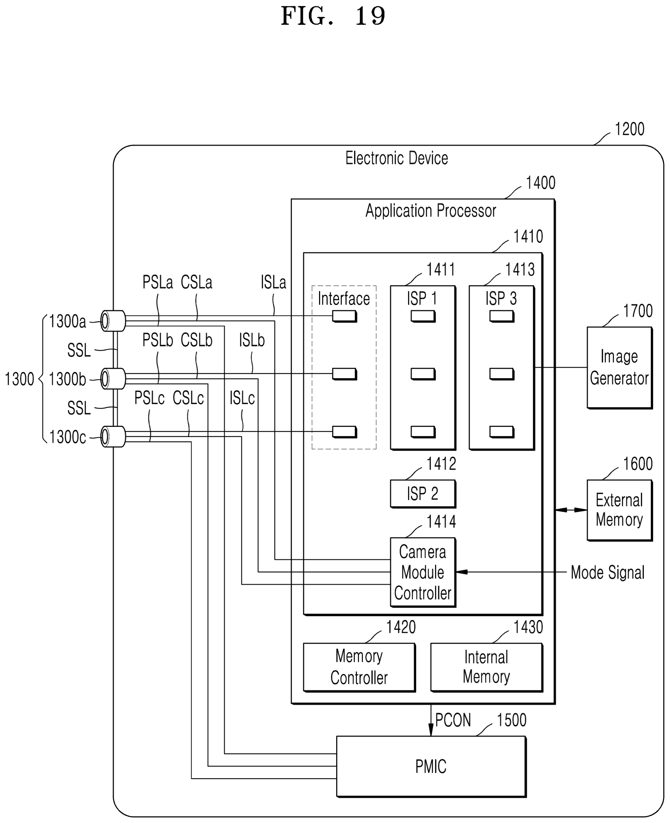

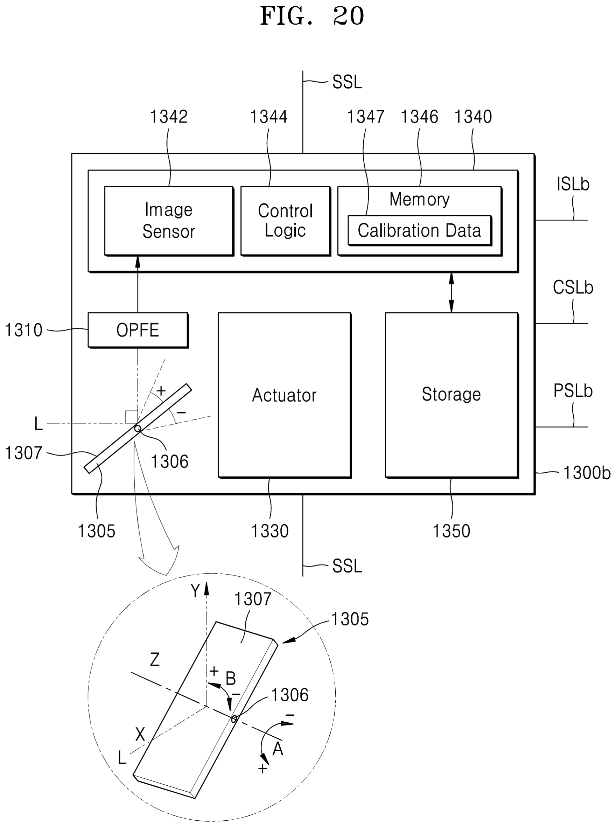

FIG. 19 is a block diagram of an electronic device including a multi-camera module, and FIG. 20 is a detailed block diagram of one camera module provided in the electronic device illustrated in FIG. 19.

Referring to FIG. 19, an electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings describe the embodiments in which three camera modules 1300a, 1300b, and 1300c are arranged, the embodiments are not limited thereto. In some embodiments, the camera module group 1300 may be modified and include only two camera modules. Also, in some embodiments, the camera module group 1300 may be modified and include n camera modules (n is a natural number of 4 or more.)

Hereinafter, the detailed configuration of the camera module 1300b is further described with reference to FIG. 19, and the descriptions may be applied to the other camera modules 1300a and 1300b as well according to embodiments.

With reference to FIG. 19, the camera module 1300b may include a prism 1305, an optical path folding element (OPFE) 1310, an actuator 1330, an image-sensing device 1340, and a storage 1350.

The prism 1305 may include a reflector 1307 made of light reflective materials, and change a direction of light L incident from outside.

In some embodiments, the prism 1305 may change the direction of the light L incident in the first direction (X direction) to the second direction (Y direction) perpendicular to the first direction (X direction.) Further, the prism 1305 may rotate the reflector 1307 made of light reflective materials around a central axis 1306 in an A direction or rotate the central axis 1306 in a B direction to change the direction of the light L incident in the first direction (X direction) to the second direction (Y direction) perpendicular to the first direction. At this time, the OPFE 1310 may also move in the third direction (Z direction) perpendicular to the first direction (X direction) and the second direction (Y direction).

In some embodiments, as illustrated in the drawings, the maximum rotation angle of the prism 1305 in the A direction may be less than or equal to 15 degrees in + A direction, and greater than 15 degrees in - A direction; however, the embodiments are not limited thereto.

In some embodiments, the prism 1305 may move within 20 degrees in + or - B direction, or within 10 degrees to 20 degrees, or within 15 degrees to 20 degrees, and the movement may be made by the same angle in + B direction and in - B direction, or a similar angle, i.e., within an angle difference of 1 degree.

In some embodiments, the prism 1305 may move the reflector 1307 including light reflective materials in the third direction (e.g., the Z direction) parallel to the extending direction of the central axis 1306.

The OPFE 1310 may include an optical lens consisting of, for example, m groups (m is a natural number.) The m lens may change an optical zoom ratio of the camera module 1300b by moving in the second direction (Y direction.) In an example case in which the initial optical zoom ratio of the camera module 1300b is Z, and m optical lens included in the OPFE 1310 are moved, the optical zoom ratio of the camera module 1300b may be changed to 3Z, 5Z, or greater than 10Z.

The actuator 1330 may move the OPFE 1310 or the optical lens to a particular position. For example, the actuator 1330 may adjust the position of the optical lens so that an image sensor 1342 may be arranged at a focal length of the optical lens for accurate sensing.

The image-sensing device 1340 may include the image sensor 1342, a control logic 1344, and a memory 1346. The image sensor 1342 may sense an image of an object by using the light L provided through the optical lens. The control logic 1344 may control overall operations of the camera module 1300b. For example, the control logic 1344 may control operations of the camera module 1300b according to control signals provided through a control signal line CSLb.

The memory 1346 may store data required for operations of the camera module 1300b, such as calibration data 1347. The calibration data 1347 may include information necessary for the camera module 1300b to generate image data by using the light L provided from the outside. The calibration data 1347 may include, for example, information regarding degree of rotation, information regarding focal length, information regarding optical axis, etc. as described above. In an example case in which the camera module 1300b is implemented in the form of multi state camera in which a focal length varies according to a position of an optical lens, the calibration data 1347 may include information regarding a focal length according to a position (or a state) of the optical lens, and auto focusing.

The storage 1350 may store image data sensed through the image sensor 1342. The storage 1350 may be arranged outside of the image-sensing device 1340, and may be implemented in a structure in which the storage 1350 and a sensor chip constituting the image-sensing device 1340 are stacked. In some embodiments, the storage 1350 may be implemented as an electrically erasable programmable read-only memory (EEPROM), but the embodiments are not limited thereto.

With reference to FIGS. 19 and 20, in some embodiments, each of the plurality of camera modules 1300a, 1300b, and 1300c may include the actuator 1330. Accordingly, each of the plurality of camera modules 1300a, 1300b, and 1300c may include the same or similar calibration data 1347 according to an operation of the actuator 1330 included therein.

In some embodiments, one camera module (e.g., 1300b) of the plurality of camera modules 1300a, 1300b, and 1300c may be a folded lens camera module including the prism 1305 and the OPFE 1310 described above, and the rest of the camera modules (e.g., 1300a and 1300b) may be a vertical camera module which does not include the prism 1305 and the OPFE 1310. However, the embodiments are not limited thereto.

In some embodiments, one camera module (e.g., 1300c) of the plurality of camera modules 1300a, 1300b, and 1300c may be, for example, a vertical depth camera extracting depth information by using infrared ray (IR).

In some embodiments, at least two camera modules (e.g., 1300a and 1300b) of the plurality of camera modules 1300a, 1300b, and 1300c may have different fields of view. In this case, for example, at least two camera modules (e.g., 1300a and 1300b) of the plurality of camera modules 1300a, 1300b, and 1300c may have different optical lens, but the disclosure is not limited thereto.

Further, in some embodiments, fields of view of the plurality of camera modules 1300a, 1300b, and 1300c may be different from each other. In this case, optical lenses included in the plurality of camera modules 1300a, 1300b, and 1300c may also be different from each other, but the disclosure is not limited thereto.

In some embodiments, the plurality of camera modules 1300a, 1300b, and 1300c may be physically separated from each other. That is, a sensing area of one image sensor 1342 is not divided to be used by the plurality of camera modules 1300a, 1300b, and 1300c, but an independent image sensor 1342 may be arranged in each of the plurality of camera modules 1300a, 1300b, and 1300c.

Referring back to FIG. 19, the application processor 1400 may include an image processing device 1410, a memory controller 1420, and an internal memory 1430. The application processor 1400 may be implemented separately from the plurality of camera modules 1300a, 1300b, and 1300c. For example, the application processor 1400 and the plurality of camera modules 1300a, 1300b, and 1300c may be implemented in separate semiconductor chips.

The image processing device 1410 may include a plurality of image processors 1411, 1412, and 1413 and a camera module controller 1414.

Image data generated from each of the camera modules 1300a, 1300b, and 1300c may be provided to the image processing device 1410 through image signal lines ISLa, ISLb, and ISLc separated from each other. Such image data transmission may be performed by, for example, a camera serial interface (CSI) based on a mobile industry processor interface (MPI), but the embodiments are not limited thereto.

The image data transmitted to the image processing device 1410 may be stored in the external memory 1600 before being transmitted to the image processors 1411 and 1412. The image data stored in the external memory 1600 may be provided to the image processor 1411 and/or the image processor 1412. The image processor 1411 may correct the received image data to generate a video. The image processor 1412 may correct the received image data to generate a still image. For example, the image processors 1411 and 1412 may perform a preprocessing operation such as color calibration, gamma correction, etc. on the image data.

The image processor 1411 may include sub-processors. In an example case in which the number of the sub-processors is the same as the number of the camera modules 1300a, 1300b, and 1300c, each sub-processor may process image data provided from one camera module. In an example case in which the number of the sub-processors is smaller than the number of the camera modules 1300a, 1300b, and 1300c, at least one of the sub-processors may process the image data provided from the plurality of camera modules by using a timing sharing process. Image data processed by the image processor 1411 and/or the image processor 1412 may be stored in the external memory 1600 before being transmitted to the image processor 1413. The image data stored in the external memory 1600 may be transmitted to the image processor 1412. The image processor 1412 may perform a post-processing operation such as noise correction, sharpen correction, etc. on the image data.

The image data processed by the image processor 1413 may be provided to the image generator 1700. The image generator 1700 may generate a final image by using the image data provided from the image processor 1413 according to image generating information or a mode signal.

Specifically, the image generator 1700 may generate an output image by merging at least some of image data generated from the camera modules 1300a, 1300b, and 1300c having different fields of view according to image generating information or a mode signal. Also, the image generator 1700 may generate an output image by selecting any one piece of image data generated from the camera modules 1300a, 1300b, and 1300c having different fields of view from each other according to image generating information or a mode signal.

In some embodiments, the image generating information may include a zoom signal or a zoom factor. Also, in some embodiments, the mode signal may be, for example, a signal based on a mode selected by a user.

In an example case in which the image generating information is a zoom signal (or a zoom factor), and each of the camera modules 1300a, 1300b, and 1300c have different fields of view from each other, the image generator 1700 may perform different operations according to a type of the zoom signal. In an example case in which the zoom signal is a first signal, the image generator 1700 may generate an output image by merging image data output from the camera module 1300a and image data output from the camera module 1300c, and then using the merged image signal and image data output from the camera module 1300b, which has not been used for data merging. In an example case in which the zoom signal is a second signal, which is different from the first signal, the image generator 1700 may not perform such image data merging, and generate an output image by selecting any one piece of image data output from each of the camera modules 1300a, 1300b, and 1300c. However, the embodiments are not limited thereto, and the method of processing image data may be modified in various ways, if necessary.

The camera module controller 1414 may provide a control signal to each of the camera modules 1300a, 1300b, and 1300c. The control signal generated from the camera module controller 1414 may be provided to the corresponding camera module 1300a, 1300b, and 1300c through the control signal lines CSLa, CSLb, and CSLc separated from each other.

In some embodiments, the control signal provided to the plurality of camera modules 1300a, 1300b, and 1300c from the camera module controller 1414 may include mode information according to the mode signal. Based on the mode information, the plurality of camera modules 1300a, 1300b, and 1300c may operate in a first operational mode and a second operational mode with respect to a sensing speed.

The plurality of camera modules 1300a, 1300b, and 1300c may generate an image signal at a first speed in the first operational mode (e.g., generate an image signal of a first frame rate), encode the image signal at a second speed which is higher than the first speed (e.g., encode an image signal of a second frame rate higher than the first frame rate), and transmit the encoded image signal to the application processor 1400. At this time, the second speed may be 30 times less than the first speed.

The application processor 1400 may store the received image signal, i.e., the encoded image signal in the internal memory 1430 or the storage 1600 outside the application processor 1400, read out from the memory 1430 or the storage 1600 the encoded image signal for decoding, and display image data generated based on the decoded image signal. For example, the image processors 1411 and 1412 of the image processing device 1410 may perform the decoding and may process image according to a decoded image signal.

The plurality of camera modules 1300a, 1300b, and 1300c may generate an image signal at a third speed which is lower than the first speed in the second operational mode (e.g., generate an image signal of a third frame rate lower than the first frame rate) and transmit the image signal to the application processor 1400. The image signal provided to the application processor 1400 may be a signal which has not been encoded. The application processor 1400 may perform the image processing on the received image signal or store the image signal in the memory 1430 or the storage 1600.

The PMIC 1500 may provide power, for example, a power voltage to each of the plurality of camera modules 1300a, 1300b, and 1300c. For example, the PMIC 1500 may provide, under the control by the application processor 1400, a first power to the camera module 1300a through a power signal line PSLa, a second power to the camera module 1300b through a power signal line PSLb, and a third power to the camera module 1300c through a power signal line PSLc.

The PMIC 1500 may generate power corresponding to each of the plurality of camera modules 1300a, 1300b, and 1300c in response to a power control signal PCON from the application processor 1400 and adjust a level of power. The power control signal PCON may include a power adjustment signal for each operational mode of the plurality of camera modules 1300a, 1300b, and 1300c. For example, the operational mode may include a low power mode, and in such a case, the power control signal PCON may include information regarding camera modules operating in the low power mode and a set power level. The levels of power provided to the plurality of camera modules 1300a, 1300b, and 1300c may be identical to or different from each other. Also, the power level may be changed dynamically.

According to an embodiment of the disclosure, there is provided an image sensor including: a sensor substrate including a plurality of unit light-sensing cells, each of the plurality of unit light-sensing cells including: a central light-sensing cell, and a plurality of peripheral light-sensing cells surrounding the central light-sensing cell; and a nano optical lens array including: a plurality of unit areas respectively corresponding to the plurality of unit light-sensing cells, and at least one nano structure configured to: condense incident light onto the plurality of unit light-sensing cells, and form a phase profile in which the incident light transmitted through the nano optical lens array is condensed onto the central light-sensing cell and the plurality of peripheral light-sensing cells, wherein the central light-sensing cell is configured to output a first image and the plurality of peripheral light-sensing cells is configured to output a second image.

Each of the plurality of unit light-sensing cells may include a plurality of light-sensing cells arranged in a 3x3 array, wherein the central light-sensing cell may be provided in a central portion of the 3x3 array, and wherein the peripheral light-sensing cells may be provided in a peripheral portion of the 3x3 array.

The phase profile of the incident light transmitted through the nano optical lens array has a peak at a center of a central corresponding area corresponding to the central light-sensing cell and at a center of each peripheral corresponding area corresponding to the peripheral light-sensing cell.

The at least one nano structure may be further configured to: separate first light of a first wavelength band, second light of a second wavelength band different from the first wavelength band, and third light of a third wavelength band different from the first wavelength band and the second wavelength band from the incident light, and respectively condense the first light, the second light and the third light onto the plurality of unit light-sensing cells.

The plurality of unit light-sensing cells may include a first unit light-sensing cell, a second unit light-sensing cell, a third unit light-sensing cell, and a fourth unit light-sensing cell, wherein the nano optical lens array may include a first unit area corresponding to the first unit light-sensing cell, a second unit area corresponding to the second unit light-sensing cell, a third unit area corresponding to the third unit light-sensing cell, and a fourth unit area corresponding to the fourth unit light-sensing cell, wherein the at least one nano structure may include a first nano structure, a second nano structure, a third nano structure and a fourth nano structure, wherein the first nano structure provided in the first unit area is arranged to separate and condense light of a first wavelength band from the incident light onto the first unit light-sensing cell, wherein the second nano structure provided in the second unit area is arranged to separate and condense light of a second wavelength band from the incident light onto the second unit light-sensing cell, wherein the third nano structure provided in the third unit area is arranged to separate and condense light of a third wavelength band from the incident light onto the third unit light-sensing cell, and wherein the fourth nano structure provided in the fourth unit area is arranged to separate and condense light of a fourth wavelength band from the incident light onto the fourth unit light-sensing cell.

The first nano structure provided in the first unit area may be arranged symmetrically with respect to a first direction, the second nano structure provided in the second unit area may be arranged symmetrically with respect to the first direction and a second direction perpendicular to the first direction, and the fourth nano structure provided in the fourth unit area may be arranged symmetrically with respect to the second direction.

The phase profile of the incident light transmitted through the nano optical lens array may have a form of a Bessel function.

Each of the plurality of unit light-sensing cells may include a plurality of light-sensing cells, and a size of the unit areas is greater than a size of the light-sensing cells.

Each of the plurality of unit light-sensing cells may include a plurality of light-sensing cells, and a size of the unit areas is identical to a size of the light-sensing cells.

According to an embodiment of the disclosure, there is provided an electronic device including: a lens assembly forming an optical image of an object; an image sensor configured to convert the optical image formed by the lens assembly into an electric signal; and a processor configured to process a signal generated from the image sensor, wherein the image sensor may include: a sensor substrate including a plurality of unit light-sensing cells, each of the plurality of unit light-sensing cells including: a central light-sensing cell, and a plurality of peripheral light-sensing cells surrounding the central light-sensing cell; and a nano optical lens array including: a plurality of unit areas respectively corresponding to the plurality of unit light-sensing cells, and at least one nano structure configured to: condense incident light onto the plurality of unit light-sensing cells, and form a phase profile in which the incident light transmitted through the nano optical lens array is condensed onto the central light-sensing cell and the plurality of peripheral light-sensing cells, wherein the central light-sensing cell is configured to output a first image and the plurality of peripheral light-sensing cells is configured to output a second image, and wherein the processor configured to obtain a high dynamic range (HDR) image based on the first image and the second image.

According to an embodiment of the disclosure, there is provided a method of generating a high dynamic range (HDR) image, the method including: obtaining a single-shot image from a central light-sensing cell of a plurality of unit light-sensing cells and a plurality of peripheral light-sensing cells surrounding the central light-sensing cell; binning images obtained from the plurality of peripheral light-sensing cells in the single-shot image; HDR-merging by using an image obtained by the binning and an image obtained from the central light-sensing cell in the single-shot image; signal processing an image obtained by the HDR-merging; and outputting a HDR image.

Although an image sensor, an electronic device including the image sensor, and a method of generating a HDR image are described with reference to the embodiments illustrated in the drawings, such embodiments are provided merely as an example, and it will be understood that various modifications and equivalents may be made from the embodiments by a person skilled in the art. Thus, the embodiments should be considered in a descriptive sense and not for purposes of limitation. The scope of rights is defined not by the detailed description of embodiments but by the appended claims, and all differences within the scope will be construed as being included in the scope of rights.

According to the embodiments, the image sensor and the electronic device including the same may improve an amount of light condensed onto the central light-sensing cell and the peripheral light-sensing cells according to the phase profile formed by the nano optical lens array.

According to the embodiments, the image sensor may utilize the pixels dynamically even in a low-light level or high-light level environment and may be applied to, for example, a HDR sensor, etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate comprising a plurality of unit light-sensing cells, each of the plurality of unit light-sensing cells comprising:
a central light-sensing cell, and
a plurality of peripheral light-sensing cells surrounding the central light-sensing cell; and
a nano optical lens array comprising:
a plurality of unit areas respectively corresponding to the plurality of unit light-sensing cells, and
at least one nano structure configured to:
condense incident light onto the plurality of unit light-sensing cells, and
form a phase profile in which the incident light transmitted through the nano optical lens array is condensed onto the central light-sensing cell and the plurality of peripheral light-sensing cells,
wherein the central light-sensing cell is configured to output a first image and the plurality of peripheral light-sensing cells is configured to output a second image.

2. The image sensor of claim 1,
wherein each of the plurality of unit light-sensing cells comprises a plurality of light-sensing cells arranged in a 3x3 array,
wherein the central light-sensing cell is provided in a central portion of the 3x3 array, and
wherein the peripheral light-sensing cells are provided in a peripheral portion of the 3x3 array.

3. The image sensor of claim 1 or 2, wherein
the phase profile of the incident light transmitted through the nano optical lens array has a peak at a center of a central corresponding area corresponding to the central light-sensing cell and at a center of each peripheral corresponding area corresponding to the peripheral light-sensing cell.

4. The image sensor of any preceding claim, wherein
the at least one nano structure is further configured to:
separate first light of a first wavelength band, second light of a second wavelength band different from the first wavelength band, and third light of a third wavelength band different from the first wavelength band and the second wavelength band from the incident light, and
respectively condense the first light, the second light and the third light onto the plurality of unit light-sensing cells.

5. The image sensor of any preceding claim,
wherein the plurality of unit light-sensing cells comprise a first unit light-sensing cell, a second unit light-sensing cell, a third unit light-sensing cell, and a fourth unit light-sensing cell,
wherein the nano optical lens array comprise a first unit area corresponding to the first unit light-sensing cell, a second unit area corresponding to the second unit light-sensing cell, a third unit area corresponding to the third unit light-sensing cell, and a fourth unit area corresponding to the fourth unit light-sensing cell,
wherein the at least one nano structure comprises a first nano structure, a second nano structure, a third nano structure and a fourth nano structure,
wherein the first nano structure provided in the first unit area is arranged to separate and condense light of a first wavelength band from the incident light onto the first unit light-sensing cell,
wherein the second nano structure provided in the second unit area is arranged to separate and condense light of a second wavelength band from the incident light onto the second unit light-sensing cell,
wherein the third nano structure provided in the third unit area is arranged to separate and condense light of a third wavelength band from the incident light onto the third unit light-sensing cell, and
wherein the fourth nano structure provided in the fourth unit area is arranged to separate and condense light of a fourth wavelength band from the incident light onto the fourth unit light-sensing cell.

6. The image sensor of claim 5, wherein
the first nano structure provided in the first unit area is arranged symmetrically with respect to a first direction,
the second nano structure provided in the second unit area is arranged symmetrically with respect to the first direction and a second direction perpendicular to the first direction, and
the fourth nano structure provided in the fourth unit area is arranged symmetrically with respect to the second direction.

7. The image sensor of any preceding claim, wherein
the phase profile of the incident light transmitted through the nano optical lens array has a form of a Bessel-function-type distribution.

8. The image sensor of any preceding claim, wherein
each of the plurality of unit light-sensing cells comprises a plurality of light-sensing cells, and
a size of the unit areas is greater than a size of the light-sensing cells.

9. The image sensor of any preceding claim, wherein
each of the plurality of unit light-sensing cells comprises a plurality of light-sensing cells, and
a size of the unit areas is identical to a size of the light-sensing cells.

10. An electronic device comprising:
a lens assembly forming an optical image of an object;
an image sensor according to any preceding claim configured to convert the optical image formed by the lens assembly into an electric signal; and
a processor configured to process a signal generated from the image sensor, and
wherein the processor configured to obtain a high dynamic range (HDR) image based on the first image and the second image.

11. A method of generating a high dynamic range (HDR) image, the method comprising:
obtaining a single-shot image from a central light-sensing cell of a plurality of unit light-sensing cells and a plurality of peripheral light-sensing cells surrounding the central light-sensing cell;
binning images obtained from the plurality of peripheral light-sensing cells in the single-shot image;
HDR-merging by using an image obtained by the binning and an image obtained from the central light-sensing cell in the single-shot image;
signal processing an image obtained by the HDR-merging; and
outputting a HDR image.

12. The method of claim 11, wherein
each of the plurality of unit light-sensing cells includes a plurality of light-sensing cells arranged in a 3x3 array, the central light-sensing cell is provided in a central portion of the 3x3 array, and the peripheral light-sensing cells are provided in a peripheral portion of the 3x3 array.
